(19) Europäisches Patentamt / European Patent Office / Office européen des brevets

(11) **EP 2 829 887 B1**

## (12) EUROPEAN PATENT SPECIFICATION

(45) Date of publication and mention
of the grant of the patent:
**25.09.2019 Bulletin 2019/39**

(51) Int Cl.:
***G01R 31/08*** *(2006.01)*

(21) Application number: **14305836.0**

(22) Date of filing: **03.06.2014**

(54) **Method and device for estimating angle of zero-sequence voltage in single-phase earth fault**

Verfahren und Vorrichtung zur Schätzung des Winkels der Spannung im Nullsystem bei einphasigem Erdschluss

Procédé et dispositif d'estimation d'angle de tension séquence-zéro de défaut à la terre monophasé

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.07.2013 CN 201310314222**

(43) Date of publication of application:
**28.01.2015 Bulletin 2015/05**

(73) Proprietor: **Schneider Electric Industries SAS 92500 Rueil-Malmaison (FR)**

(72) Inventors:
• **Li, Rong**
 **201114 Shanghai (CN)**
• **Ren, Rui**
 **201114 Shanghai (CN)**

(74) Representative: **Manitz Finsterwald
Patent- und Rechtsanwaltspartnerschaft mbB
Martin-Greif-Strasse 1
80336 München (DE)**

(56) References cited:
**EP-A1- 1 018 027        EP-A1- 2 192 416
EP-A2- 1 139 539        EP-A2- 1 195 875
EP-A2- 1 724 597        EP-B- 1 682 909
WO-A2-2009/081215     CN-A- 103 149 502
US-A1- 2003 074 146**

• **BALCEREK P ET AL: "Centralized substation level protection for determination of faulty feeder in distribution network", POWER AND ENERGY SOCIETY GENERAL MEETING, 2012 IEEE, IEEE, 22 July 2012 (2012-07-22), pages 1-6, XP032466104, DOI: 10.1109/PESGM.2012.6345484 ISBN: 978-1-4673-2727-5**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present disclosure relates to locating of a single-phase earth fault in a distribution network with Decentralized Generating Devices (DGs), and particularly to a method and a device for estimating an angle of a zero-sequence voltage when the single-phase earth fault occurs in the distribution network. The features of the preamble of the independent claims are known from EP 1 682 909 B1.

BACKGROUND

A single-phase earth fault is a fault caused by a short circuit between one phase and earth via an earth fault impedance. Currently a fault indicator is developed for a grid in which its energy flows uni-directionally, and may be disposed at any position in the grid and indicate a fault position according to a flow direction of the energy. For example, the fault indicator lights a red light(s) when the fault occurs at a downstream of the fault indicator, and lights a green light(s) or does not light when the fault occurs at an upstream of the fault indicator.

However, with a popularization of decentralized generating devices, the energy may flows bi-directionally as the fault occurs after the decentralized generating device is incorporating into the grid. In terms of a specified line or cable, maybe both sides of it are power supplies, and the above fault indictor fails to indicate an earth fault position accurately according to the flow direction of the energy in this case.

Nowadays a technique for locating the single-phase earth fault by incorporating a voltage sensor into an earth fault detection device has been proposed, and a Low Power Voltage Transformer (LPVT) which can provide a voltage magnitude and a voltage angle, both are very accurate, has been proposed to function as the voltage sensor. A utilization rate of this technique is low now, however, because the voltage sensor is high-cost and is not popular in the existing grid.

In the existing distribution network, a Voltage Presence Indication System (VPIS) is applied greatly to indicate a voltage presence state. The Voltage Presence Indication System (VPIS) is low-cost and is used very popularly, which can provide a very accurate voltage angle but may not provide an accurate voltage magnitude, for example, an error in its voltage magnitude may reach 30% approximately or even higher. Therefore a direct summation of three phase voltages provided by the VPIS to obtain a residual voltage (VR) (or a zero-sequence voltage) will induce an unacceptable angular error (may be reach 180° in extreme cases).

Therefore it is required a method and device capable of estimating an angle of the zero-sequence voltage with the known voltage angles of the respective phases when the single-phase earth fault occurs in the distribution network.

SUMMARY

In the present disclosure, there are provided a method and a device, as defined in the independent claims, for estimating an angle of a zero-sequence voltage when a single-phase earth fault occurs in a distribution network, which may estimate the angle of the zero-sequence voltage with known voltage angles of respective phases and eliminate a requirement for a voltage sensor which is high-lost.

According to an aspect of the present disclosure, there is provided a method for estimating an angle of a zero-sequence voltage when a single-phase earth fault occurs in a distribution network, comprising: detecting angles of respective phase voltages in three phase voltages; determining a neutral earthing type of the distribution network; and estimating the angle of the zero-sequence voltage when the single-phase earth fault occurs in the distribution network with the detected angles of the respective phase voltages, according to the neutral earthing type of the distribution network.

Preferably, said estimating the angle of the zero-sequence voltage when the single-phase earth fault occurs at an A-phase comprises: setting a magnitude of a B-phase voltage as a predetermined reference value $FB$; estimating an A-phase voltage and a C-phase voltage by using the magnitude of the B-phase voltage and the angles of the A-phase voltage, the B-phase voltage and the C-phase voltage; and calculating the angle of the zero-sequence voltage by using the B-phase voltage and the estimated A-phase voltage and the estimated C-phase voltage.

Preferably, in a case that the neutral earthing type of the distribution network is a neutral resonant earthing or a neutral isolated earthing, real parts and imaginary parts of the B-phase, the C-phase and the A-phase are calculated by following equations:

$$\mathrm{Re}Vb = FB \cdot \cos\varphi_B, \mathrm{Im}Vb = FB \cdot \sin\varphi_B,$$

$$\mathrm{Re}Vc = \frac{k3}{k4}, \quad \mathrm{Im}Vc = \mathrm{Re}Vc \cdot \tan(\varphi_C),$$

$$\mathrm{Re}Va = k1 \cdot \mathrm{Re}Vc + k2, \quad \mathrm{Im}Va = \mathrm{Re}Va \cdot \tan(\varphi_A);$$

where ReVa is the real part of the A-phase voltage, ImVa is the imaginary part of the A-phase voltage, ReVb is the real part of the B-phase voltage, ImVb is the imaginary part of the B-phase voltage, ReVc is the real part of the C-phase voltage, ImVc is the imaginary part of the C-phase voltage, $\varphi_A$ is an angle of the A-phase voltage, $\varphi_B$ is an angle of the B-phase voltage, and $\varphi_C$ is an angle of the C-phase voltage, and

$$\begin{cases} k1 = \dfrac{-\dfrac{\sqrt{3}}{2} + 0.5 \cdot \tan(\varphi_C)}{\tan(\varphi_A)} \\[3em] k2 = \dfrac{\dfrac{\sqrt{3}}{2} \cdot \cos\varphi_B + 0.5 \cdot \sin\varphi_B}{\tan(\varphi_A)} FB \\[3em] k3 = FB\sin\varphi_B + \dfrac{\sqrt{3}}{2} \cdot k2 - 0.5 \cdot k2 \cdot \tan(\varphi_A) \\[1.5em] k4 = \tan(\varphi_C) + \dfrac{\sqrt{3}}{2} - k1 \cdot \dfrac{\sqrt{3}}{2} - 0.5\tan(\varphi_C) + 0.5 \cdot k1 \cdot \tan(\varphi_A) \end{cases}.$$

Preferably, in a case that the neutral earthing type of the distribution network is a neutral solidly earthing, a magnitude *FC* of the C-phase voltage is determined as a predetermined multiple of the magnitude *FB* of the B-phase voltage, an angle of a negative-sequence impedance at an earth fault detection device is estimated, and the real part and imaginary part of the A-phase voltage are estimated according to following equations:

$$\mathrm{Re}Va = \frac{-\mathrm{Im}Vsum + \tan(\varphi_{V2}) \cdot \mathrm{Re}Vsum}{\tan(\varphi_A) - \tan(\varphi_{V2})},$$

$$\mathrm{Im}Va = \mathrm{Re}Va \cdot \tan(\varphi_A),$$

where ReVsum is a real part of $\dot{V}_{sum}$, ImVsum is an imaginary part of the $\dot{V}_{sum}$, $\dot{V}_{sum} = \alpha^2 \cdot FB \cdot e^{j\varphi B} + \alpha \cdot FC \cdot e^{j\varphi C}$,

$$\alpha = -0.5 + j\frac{\sqrt{3}}{2};$$

$\varphi_A$ is the angle of the A-phase voltage, $\varphi_B$ is the angle of the B-phase voltage, and $\varphi_C$ is the angle of the C-phase voltage; $\varphi_{V2} = \varphi_{I2} + 180° + \varphi_{Z2}$, $\varphi_{I2}$ is an angle of a negative-sequence current, $\varphi_{Z2}$ is an angle of the negative-sequence impedance, and $\varphi_{V2}$ is an angle of a negative-sequence voltage.

According to another aspect of the present disclosure, there is provided a device for estimating an angle of a zero-sequence voltage when a single-phase earth fault occurs in a distribution network, comprising: an angle detector for an A-phase voltage, an angle detector for a B-phase voltage and an angle detector for a C-phase voltage; and an angle estimator for a zero-sequence voltage for estimating the angle of the zero-sequence voltage when the single-phase earth fault occurs in the distribution network with angles of the respective phase voltages detected by the angle detector for the A-phase voltage, the angle detector for the B-phase voltage and the angle detector for the C-phase voltage, according to a neutral earthing type of the distribution network.

Preferably, the device for estimating the angle of the zero-sequence voltage further comprises an A-phase current transformer, a B-phase current transformer and a C-phase current transformer.

With the method and device for estimating the angle of the zero-sequence voltage when the single-phase earth fault occurs in the distribution network according to the embodiments of the present disclosure, the angle of the zero-sequence voltage may be estimated with the angles of the three phase voltages provided by the existing VPIS without the accurate magnitudes of the three phase voltages, so that the detection for the single-phase earth fault is simpler and easier, and the cost of the earth fault detection device is reduced.

BRIEF DESCRIPTION OF THE DRAWINGS

The disclosure will be easily understood with the aid of the following detail description with reference to the accompanying drawings, in which a same reference sign refers to units or elements with a same structure and in which:

Fig.1 schematically illustrates a schematic diagram of a distribution network with Decentralized Generating devices;
Fig.2A illustrates a schematic diagram of a forward zone in which a forward earth fault is detected and a reverse zone in which a reverse earth fault is detected in a phase angle mode;
Fig.2B illustrates a schematic diagram of a forward zone in which a forward earth fault is detected and a reverse zone in which a reverse earth fault is detected in an active current mode;
Fig.2C illustrates a schematic diagram of a forward zone in which a forward earth fault is detected and a reverse zone in which a reverse earth fault is detected in a reactive current mode;
Fig.3 illustrates a flowchart for a method for estimating an angle of a zero-sequence voltage when a single-phase earth fault occurs in a distribution network according to the embodiments of the present disclosure;
Fig.4 illustrates a flowchart for a process for estimating the angle of the zero-sequence voltage with detected angles of the respective phase voltages according to the embodiments of the present disclosure;
Fig.5 illustrates a flowchart of steps for estimating an A-phase voltage and a C-phase voltage in a Mode 2;
Fig.6 schematically illustrates a relationship between a CR value and a ratio of the magnitude of the B-phase voltage and that of the C-phase voltage;
Fig.7 schematically illustrates a connection diagram of a earth fault detection device in the distribution network;
Fig.8 schematically illustrates a connection diagram for a earth fault detection device D1, which is far away from the decentralized generating device and loads while locates at a medium voltage side in the distribution network, and a earth fault detection device D2, which is near to the decentralized generating device while locates at the medium voltage side in the distribution network;
Fig.9 schematically illustrates an equivalent diagram of a negative-sequence network for the earth fault detection device D1, which is far away from the decentralized generating device and loads while locates at the medium voltage side in the distribution network, and the earth fault detection device D2, which is near to the decentralized generating device while locates at the medium voltage side in the distribution network;
Fig.10 schematically illustrates a connection diagram for a earth fault detection device D3 which is near to the loads while locates at the medium voltage side in the distribution network;
Fig.11 schematically illustrates an equivalent diagram of the negative-sequence network for the earth fault detection device D3 which is near to the loads while locates at the medium voltage side in the distribution network;
Fig.12 illustrates a magnitude of an A-phase voltage estimated by the earth fault detection device D1;
Fig.13 illustrates a magnitude of an A-phase voltage estimated by the earth fault detection device D2;
Fig.14 illustrates a magnitude of an A-phase voltage estimated by the earth fault detection device D3; and
Fig.15 illustrates a schematic block diagram of a device for estimating an angle of a zero-sequence voltage when a single-phase earth fault occurs in a distribution network according to the embodiments of the present disclosure.

DETAILED DESCRIPTION

Following descriptions are given with reference to the accompanying drawings to assist those skilled in the art to fully understand the exemplary embodiments of the present disclosure as defined by claims and its equivalents. The following descriptions may include various details to assist in understanding, and these details should be construed as illustrative. Therefore, those skilled in the art should understand that various modifications and variations in forms and details can be made in the exemplary embodiments without departing from the spirit or scope of the present disclosure. Likewise, for the sake of conciseness and clarity, descriptions for well-known functions and structures are omitted.

The terminology used herein is for the purpose of describing particular embodiments only and is not intended to limit the present disclosure. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Applications of the Embodiments of the present disclosure are not limited to any particular system, but can be used with any three-phase system. For example, the feeders may be overhead lines, underground cables, or mixture of overhead lines and underground cables.

Hereinafter, embodiments of the present disclosure are described by taking the distribution network as an example, but those skilled in the art should understand that the power system to which the embodiments of the present disclosure may be applied may be a transmission grid, a distribution network or elements in the transmission grid or distribution network, and may include one or more feeders. Furthermore, the embodiments of the present disclosure are not limited to be used in systems adopting 50Hz or 60Hz baseband, and are not limited to any particular voltage level.

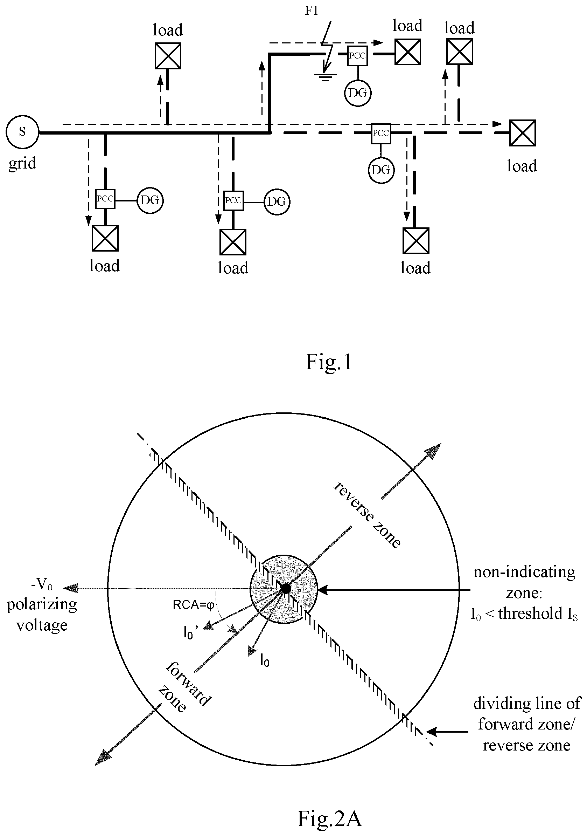

Fig.1 schematically illustrates a schematic diagram of a distribution network with Decentralized Generating devices. A trunk grid S, decentralized generating devices DGs and loads are included in the distribution network. In Fig.1, PCC represents a connection point between the decentralized generating device DG and the trunk grid S. Generally, an earth fault detection device is installed at the trunk grid S side of the PCC and not installed at the decentralized generating device DG side. Further, F1 represents a single-phase earth fault in Fig.1, and following descriptions are made by making a A-phase earth fault as an example in order to simplify the description.

In Fig.1, specified reference directions of currents flowing through current sensors are denoted by thin dot lines, and a direction of the single-phase earth fault in the distribution network is determined according to the specified reference directions of the currents. For example, the earth fault detection device may detect a forward fault when the single-phase earth fault locates at a downstream of the earth fault detection device in the distribution network, that is, at the downstream of the earth fault detection device along the reference direction of the current; otherwise, the earth fault detection device may detect a reverse fault when the single-phase earth fault locates at a upstream of the earth fault detection device in the distribution network, that is, at the upstream of the earth fault detection device against the reference direction of the current. Therefore, in Fig.1, the earth fault detection devices installed on bold solid lines may detect the forward faults, while the earth fault detection devices installed on dotted solid lines may detect the reverse faults. Additionally, the earth fault detection devices installed on the dotted solid lines may also not indicate any faults, because such earth fault detection device may be far away from a position at which the single-phase earth fault occurs and a residual current (or a zero-sequence current) at such earth fault detection device is quite small.

Currently, it is considered that the single-phase earth fault is detected in a case that the zero-sequence current exceeds a predetermined current threshold and its duration exceeds a predetermined duration (for example, 100ms), and a directional detection of the single-phase earth fault is based on a magnitude and an angle of the zero-sequence current and a magnitude and an angle of a zero-sequence voltage.

In a three-phase distribution network, there have been several different methods for the directional detection of the single-phase earth fault according to different neutral earthing types in the distribution network. Several common neutral earthing types in the distribution network include: a neutral solidly earthing, a neutral isolated earthing, a neutral impedance earthing and a neutral resonant earthing (or a compensation earthing).

In the directional detection of the single-phase earth fault described below, an angle leading the angle of the zero-sequence voltage for 180° (i.e., an angle of a negative zero-sequence voltage) is considered as a reference axis, and a forward direction is a counterclockwise direction. An angle relationship between the zero-sequence voltage and the zero-sequence current is depending on a zero-sequence impedance of the grid at the detection position, such as the neutral earthing type, an earth resistance of the earth fault, a relative position of the earth fault with respect to the earth fault detection device and the like.

**Phase Angle Mode**

In this mode, the direction of the single-phase earth fault may be detected only with the angles of the zero-sequence voltage and the zero-sequence current.

In particular, the direction of the single-phase earth fault may be determined based on following criteria.

Forward Earth Fault:

$$-90° < \varphi(I_0) - \varphi(V_0 + 180°) - RCA < 90° \tag{1}$$

Reverse Earth Fault:

$$90° < \varphi(I_0) - \varphi(V_0 + 180°) - RCA < 270° \qquad (2)$$

where $\varphi(V_0 + 180°)$ represents the angle leading the angle of the zero-sequence voltage for 180° (i.e., the angle of the negative zero-sequence voltage), $\varphi(I_0)$ represents the angle of the zero-sequence current, RCA represents a relay characteristic angle and is used for compensating a phase displacement caused by an earth fault loop impedance. The RCA is set as a positive value when the zero-sequence current leads the negative zero-sequence voltage, and is set as a negative value when the zero-sequence current lags the negative zero-sequence voltage.

Fig.2A illustrates a schematic diagram of a forward zone in which the forward earth fault is detected and a reverse zone in which the reverse earth fault is detected in the phase angle mode, wherein a direction of the negative zero-sequence voltage -Vo is considered as the reference axis, and the forward zone and the reverse zone each have 180° in the plane, respectively. Furthermore, a non-indicating zone in Fig.2A represents a case that the magnitude of the zero-sequence voltage is less than a threshold Is and accordingly no earth fault is detected.

In Fig.2A, $I_0$ and $I_0'$ represent two boundary conditions in the case that the zero-sequence voltage leads to the negative zero-sequence voltage -Vo, respectively, and RCA represents an average angle of an angle of $I_0$ and an angle of $I_0'$.

**Active Current Mode**

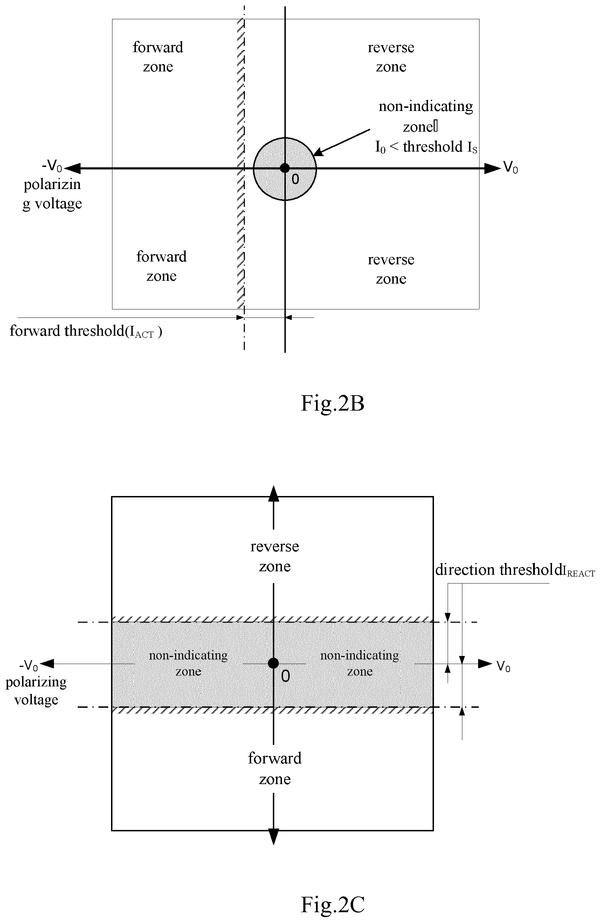

In a case that the neutral earthing type in the distribution network is the neutral resonant earthing or the neutral impedance earthing, an active component of the zero-sequence current may be calculated with the angle of the zero-sequence voltage together with the angle and magnitude of the zero-sequence current, and the direction of the single-phase earth fault may be detected with the active component of the zero-sequence current. Fig.2B illustrates a schematic diagram of the forward zone in which the forward earth fault is detected and the reverse zone in which the reverse earth fault is detected in the active current mode.

In particular, the direction of the single-phase earth fault is determined based on following criteria.

Forward Earth Fault:

$$I_0 \times \cos\varphi > I_{ACT} \qquad (3)$$

Reverse Earth Fault:

$$I_0 \times \cos\varphi \leq I_{ACT} \qquad (4)$$

where $I_0$ represents the magnitude of the zero-sequence current, $\varphi$ represents an included angle between the zero-sequence current and the zero-sequence voltage, and $I_{ACT}$ represents a positive active current threshold for the forward single-phase earth fault, for example, may be set as 2A.

**Reactive Current Mode**

In a case that the neutral earthing type in the distribution network is the neutral isolated earthing, a reactive component of the zero-sequence current may be calculated with the angle of the zero-sequence voltage together with the angle and magnitude of the zero-sequence current, and the direction of the single-phase earth fault may be detected with the reactive component of the zero-sequence current. Fig.2C illustrates a schematic diagram of the forward zone in which the forward earth fault is detected and the reverse zone in which the reverse earth fault is detected in the reactive current mode.

In the case of the neutral isolated earthing, the zero-sequence current is mostly a reactive current component, and the zero-sequence current may lead the negative zero-sequence voltage for 90° during the forward single-phase earth fault while the zero-sequence current may lag the negative zero-sequence voltage for 90° during the reverse single-phase earth fault. Such mode is very close to the phase angle mode where the RCA is set as 90°, and a difference therebetween lies in that the non-indicating zone is decided by a reactive current threshold $I_{REACT}$.

In particular, the direction of the single-phase earth fault is judged based on following criteria.

Forward Earth Fault:

$$I_0 \times \sin\varphi > +I_{REACT} \qquad (5)$$

Reverse Earth Fault:

$$\mathrm{I}_0 \times \sin\varphi \leq -\mathrm{I}_{\mathrm{REACT}} \qquad (6)$$

wherein $\mathrm{I}_0$ represents the magnitude of the zero-sequence current, $\varphi$ represents an included angle between the zero-sequence current and the zero-sequence voltage, and $\mathrm{I}_{\mathrm{REACT}}$ represents a positive reactive current threshold for the forward single-phase earth fault, for example, may be set as 2A.

As described previously, the angle of the zero-sequence voltage is required to be determined at first in all of the three different methods for the directional detection. Currently, a Low Power Voltage Transformer (LPVT) has been proposed to be used as a voltage sensor for acquiring the magnitudes and angles of the respective phase voltages, and in turn the angle of the zero-sequence voltage may be acquired by calculation. However, a utilization rate of the Low Power Voltage Transformer (LPVT) is low now in the distribution network because of its expensive price, although it may provide very accurate voltage angle and very accurate voltage magnitude.

On the other hand, as described previously, the Voltage Presence Indication System (VPIS) has been applied greatly to indicate the voltage presence state in the distribution network. The Voltage Presence Indication System (VPIS) has a low cost and is used very popularly, which can provide a very accurate voltage angle but may not provide an accurate voltage magnitude.

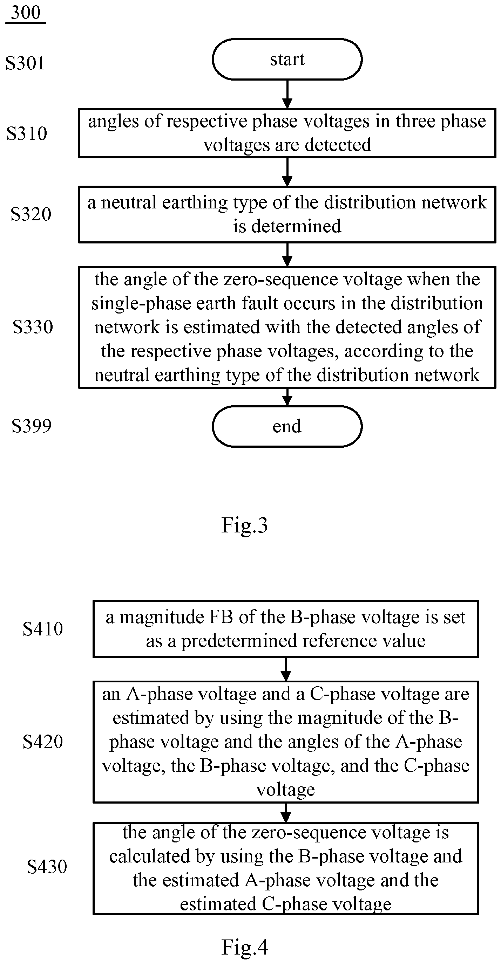

The present disclosure tends to estimate the angle of the zero-sequence voltage with the angles of the three phase voltages provided by the existing VPIS system. The method and device for estimating the angle of the zero-sequence voltage proposed in the present disclosure may be described below in connection with Figs.3-14.

Generally, there may be following combinations of the neutral earthing type in the distribution network and the neutral earthing type of the decentralized generating device.

Table 1

| Case | Neutral Earthing Type in Distribution Network | Neutral Earthing Type of Decentralized Generating Device |
|------|-----------------------------------------------|----------------------------------------------------------|
| 1 | Solidly | Solidly |
| 2 | Solidly | Impedance |
| 3 | Solidly | Isolated |
| 4 | Resonant | Isolated |
| 5 | Isolated | Isolated |

Fig.3 illustrates a flowchart for a method for estimating an angle of a zero-sequence voltage when a single-phase earth fault occurs in a distribution network according to the embodiments of the present disclosure. Since the residual voltage is three times of the zero-sequence voltage, that is, the amplitude of the residual voltage is three times of that of the zero-sequence voltage and the angle of the residual voltage is same as that of the zero-sequence voltage, in the following description, in terms of angle calculation, the zero-sequence voltage and the residual voltage may be interchanged indiscriminately.

In a step S310, angles of respective phase voltages in three phase voltages are detected. As described previously, the angles of the respective phase voltages may be provided with the existing VPIS system. However the present disclosure is not limited thereto, and the angles of the respective phase voltages may be provided by other voltage angle detecting device. It should be understood that the present disclosure tends to complete an estimation of the angle of the zero-sequence voltage without acquiring accurate information on voltage magnitudes, therefore in this context, the measure for only acquiring the information on the voltage angles without acquiring the accurate information on the voltage magnitudes may comprise any detecting measures for the voltage angles capable of realizing this object which is existing or may be developed in future of course, instead of being limited to the existing VPIS system.

In a step S320, a neutral earthing type of the distribution network is determined. As shown in Table 1, following description may involve the following cases of the neutral solidly earthing in the distribution network, the neutral resonant earthing in the distribution network and the neutral isolated earthing in the distribution network.

In a step S330, the angle of the zero-sequence voltage when the single-phase earth fault occurs in the distribution network is estimated with the detected angles of the respective phase voltages, according to the neutral earthing type of the distribution network.

Fig.4 illustrates a flowchart for a process for estimating the angle of the zero-sequence voltage with the detected angles of the respective phase voltages according to the embodiments of the present disclosure. In the following description, it is always assumed that the single-phase earth fault occurs at an A-phase, and a B-phase and a C-phase are normal.

In a step S410, a magnitude *FB* of the B-phase voltage is set as a predetermined reference value. The predetermined reference value may be a normalized value, for example, 1, or may be a rated voltage of the distribution network system, or even may be any preset value.

In a step S420, an A-phase voltage and a C-phase voltage is estimated by using the magnitude of the B-phase voltage and the angles of the A-phase voltage, the B-phase voltage and the C-phase voltage.

In a step S430, the angle of the zero-sequence voltage is calculated by using the B-phase voltage and the estimated A-phase voltage and the estimated C-phase voltage.

For example, the angle of the zero-sequence voltage (or the residual voltage) may be calculated with a real part and an imaginary part of the A-phase voltage, a real part and an imaginary part of the B-phase voltage, and a real part and an imaginary part of the C-phase voltage:

$$\varphi_{VR} = a\tan\left(\frac{ImVa + ImVb + ImVc}{\mathrm{Re}Va + \mathrm{Re}Vb + \mathrm{Re}Vc}\right) \qquad (7)$$

wherein Re*Va* represents the real part of the A-phase voltage, ImVa represents the imaginary part of the A-phase voltage, Re*Vb* represents the real part of the B-phase voltage, ImVb represents the imaginary part of the B-phase voltage, Re*Vc* represents the real part of the C-phase voltage, and ImVc represents the imaginary part of the C-phase voltage.

There are two different modes for estimating the angle of the zero-sequence voltage according to the different cases of the neutral earthing type in the distribution network: 1. Mode 1 is for the cases of the neutral resonant earthing and the neutral isolated earthing; 2. Mode 2 is for other cases of the neutral earthing types (i.e., the neutral solidly earthing and the neutral impedance earthing).

Given following specification for the description below in order to simplify an expression:

$$\begin{cases} |\dot{V}_A| = FA \\ |\dot{V}_B| = FB \\ |\dot{V}_C| = FC \end{cases},$$

and

$$\mathrm{Re}\{\dot{V}_A\} = \mathrm{Re}Va$$

$$\mathrm{Im}\{\dot{V}_A\} = \mathrm{Im}Va$$

wherein $\dot{V}_A$, $\dot{V}_B$ and $\dot{V}_C$ represent phasors of the A-phase voltage, the B-phase voltage and the C-phase voltage, respectively, and *FA, FB* and *FC* represent the magnitudes of the A-phase voltage, the B-phase voltage and the C-phase voltage, respectively.

**Mode 1**

Regarding a combination of the above Case 4 and Case 5 in the Table 1, that is, in a case that there is a neutral resonant earthing or a neutral isolated earthing in the distribution network while there is a neutral isolated earthing in the decentralized generating devices, phase-phase voltages are nearly balanced during the single-phase earth fault, namely:

$$\begin{cases} \dot{V}_A - \dot{V}_B = \alpha(\dot{V}_B - \dot{V}_C) \\ \dot{V}_B - \dot{V}_C = \alpha(\dot{V}_C - \dot{V}_A) \end{cases}, \text{ with } \alpha = -0.5 + j\frac{\sqrt{3}}{2}.$$

Express the above equation by splitting complex voltage phasors into real and imaginary parts with help of the simplified expressions:

$$\begin{cases} \mathrm{Re}Va - \mathrm{Re}Vb + j\cdot\mathrm{Im}Va - j\cdot\mathrm{Im}Vb = (-0.5+j\frac{\sqrt{3}}{2})\cdot(\mathrm{Re}Vb - \mathrm{Re}Vc + j\cdot\mathrm{Im}Vb - j\cdot\mathrm{Im}Vc) \\ \mathrm{Re}Vb - \mathrm{Re}Vc + j\cdot\mathrm{Im}Vb - j\cdot\mathrm{Im}Vc = (-0.5+j\frac{\sqrt{3}}{2})\cdot(\mathrm{Re}Vc - \mathrm{Re}Va + j\cdot\mathrm{Im}Vc - j\cdot\mathrm{Im}Va) \end{cases}.$$

Each of above equations can be split into two equations for real parts and imaginary parts:

$$\begin{cases} \mathrm{Re}Va - \mathrm{Re}Vb = -0.5\cdot(\mathrm{Re}Vb - \mathrm{Re}Vc) - \frac{\sqrt{3}}{2}\cdot(\mathrm{Im}Vb - j\cdot\mathrm{Im}Vc) \\ \mathrm{Im}Va - \mathrm{Im}Vb = \frac{\sqrt{3}}{2}\cdot(\mathrm{Re}Vb - \mathrm{Re}Vc) - 0.5\cdot(\mathrm{Im}Vb - \mathrm{Im}Vc) \\ \mathrm{Re}Vb - \mathrm{Re}Vc = -0.5\cdot(\mathrm{Re}Vc - \mathrm{Re}Va) - \frac{\sqrt{3}}{2}\cdot(\mathrm{Im}Vc - j\cdot\mathrm{Im}Va) \\ \mathrm{Im}Vb - \mathrm{Im}Vc = \frac{\sqrt{3}}{2}\cdot(\mathrm{Re}Vc - \mathrm{Re}Va) - 0.5\cdot(\mathrm{Im}Vc - \mathrm{Im}Va) \end{cases}.$$

There are 6 unknown variables in above 4 equations.

As described previously, given that the magnitude $FB$ of the B-phase voltage is the predetermined reference value, then the real part and the imaginary part of the B-phase voltage may be expressed as follows, respectively:

$$\mathrm{Re}Vb = FB\cdot\cos\varphi_B,$$

$$\mathrm{Im}Vb = FB\cdot\sin\varphi_B,$$

where $\varphi_B$ is an angle of the B-phase voltage which can measured directly by the VPIS.

After solving the above 4 equations, there is:

$$\mathrm{Re}Vc = \frac{k3}{k4}, \quad \mathrm{Im}Vc = \mathrm{Re}Vc\cdot\tan(\varphi_C),$$

and

$$\mathrm{Re}Va = k1\cdot\mathrm{Re}Vc + k2, \quad \mathrm{Im}Va = \mathrm{Re}Va\cdot\tan(\varphi_A),$$

with

$$\left\{ \begin{array}{l} k1 = \dfrac{-\dfrac{\sqrt{3}}{2} + 0.5 \cdot \tan(\varphi_C)}{\tan(\varphi_A)} \\[3ex] k2 = \dfrac{\dfrac{\sqrt{3}}{2} \cdot \cos \varphi_B + 0.5 \cdot \sin \varphi_B}{\tan(\varphi_A)} FB \\[3ex] k3 = FB\sin \varphi_B + \dfrac{\sqrt{3}}{2} \cdot k2 - 0.5 \cdot k2 \cdot \tan(\varphi_A) \\[3ex] k4 = \tan(\varphi_C) + \dfrac{\sqrt{3}}{2} - k1 \cdot \dfrac{\sqrt{3}}{2} - 0.5\tan(\varphi_C) + 0.5 \cdot k1 \cdot \tan(\varphi_A) \end{array} \right. ,$$

where $\varphi_A$ is the angle of the A-phase voltage, $\varphi_B$ is the angle of the B-phase voltage and $\varphi_C$ is the angle of the C-phase voltage.

For example, it may assume that the magnitude $FB$ of the B-phase voltage is 1.0, namely

$$FB = \sqrt{\mathrm{Re}Vb^2 + \mathrm{Im}Vb^2} = 1.$$

Therefore, it may obtain:

$$\left\{ \begin{array}{l} k1 = \dfrac{-\dfrac{\sqrt{3}}{2} + 0.5 \cdot \tan(\varphi_C)}{\tan(\varphi_A)} \\[3ex] k2 = \dfrac{\dfrac{\sqrt{3}}{2} \cdot \cos \varphi_B + 0.5 \cdot \sin \varphi_B}{\tan(\varphi_A)} \\[3ex] k3 = \sin \varphi_B + \dfrac{\sqrt{3}}{2} \cdot k2 - 0.5 \cdot k2 \cdot \tan(\varphi_A) \\[3ex] k4 = \tan(\varphi_C) + \dfrac{\sqrt{3}}{2} - k1 \cdot \dfrac{\sqrt{3}}{2} - 0.5\tan(\varphi_C) + 0.5 \cdot k1 \cdot \tan(\varphi_A) \end{array} \right. .$$

Therefore the angle of the residual voltage may be calculated by the above equation (7), and in turn the direction of the single-phase earth fault may be determined with at least one of the above equations (1)-(6) according to the different neutral earthing type in the distribution network.

**Mode 2**

Regarding a combination of above Cases 1-3 in the Table 1, that is, in a case that there is a neutral solidly earthing in the distribution network, the phase-phase voltages are no longer balanced. It is also assumed that the single-phase earth fault occurs at the A-phase and the magnitude $FB$ of the B-phase voltage is the predetermined reference value.

Because the angles of the three phase voltages including the A-phase voltage, the B-phase voltage and the C-phase voltage may be measured directly, magnitudes of the A-phase voltage and the C-phase voltage are required to be determined in order to obtain the angle of the residual voltage, given that the magnitude $FB$ of the B-phase voltage is the predetermined reference value.

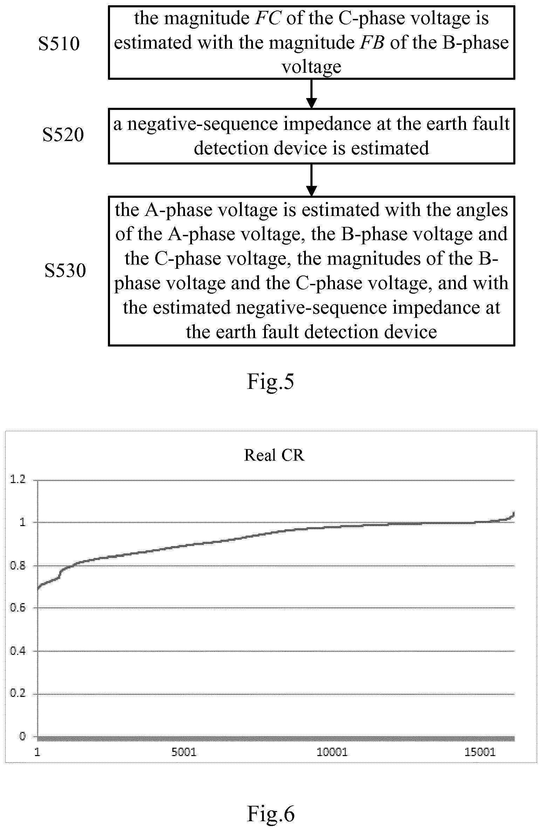

Fig.5 illustrates a flowchart of the step for estimating the A-phase voltage and the C-phase voltage in the Mode 2.

In a step S510, the magnitude $FC$ of the C-phase voltage is estimated with the magnitude $FB$ of the B-phase voltage.

In a step S520, a negative-sequence impedance at the earth fault detection device is estimated.

In a step S530, the A-phase voltage is estimated with the angles of the A-phase voltage, the B-phase voltage and the C-phase voltage, the magnitudes of the B-phase voltage and the C-phase voltage, and with the estimated negative-sequence impedance at the earth fault detection device.

A process for estimating the magnitude of the C-phase voltage in the step S510 will be described below at first.

Defining CR as a ratio of the magnitudes of the B-phase voltage and the C-phase voltage:

$$CR = \frac{|\dot{V}_B|}{|\dot{V}_C|} = \frac{V_B}{V_C}.$$

It has found that a positive-sequence current component $\dot{I}_{f1}$ and a negative-sequence current component $\dot{I}_{f2}$ are same as a zero-sequence current component $\dot{I}_{f0}$ in the case that the single-phase earth fault occurs in the distribution network, and may be expressed as:

$$\dot{I}_{f1} = \dot{I}_{f2} = \dot{I}_{f0} = \frac{\dot{V}_{fa[0]}}{Z_1 + Z_2 + Z_0 + 3R_f} = \frac{\dot{V}_{fa[0]}}{2Z_1 + Z_0 + 3R_f},$$

where $\dot{V}_{fa[0]}$ is the A-phase voltage at the fault position before the A-phase earth fault occurs, $Z_1$ is an equivalent positive-sequence impedance, $Z_2$ is an equivalent negative-sequence impedance and is equal to $Z_1$ approximately, $Z_0$ is an equivalent zero-sequence impedance, and $R_f$ is an earth resistence of the earth fault.

Therefore a positive-sequence voltage component $\dot{V}_{f1}$, a negative-sequence voltage component $\dot{V}_{f2}$ and a zero-sequence voltage component $\dot{V}_{f0}$ at the fault position are as follows, respectively:

$$\begin{cases} \dot{V}_{f1} = \dot{V}_{fa[0]} - Z_1 \cdot \dot{I}_{f1} \\ \dot{V}_{f2} = -Z_1 \cdot \dot{I}_{f2} \\ \dot{V}_{f0} = -Z_0 \cdot \dot{I}_{f0} \end{cases}.$$

Therefore the voltages (two healthy phase voltages) at the B-phase and the C-phase where no earth fault occurs may be expressed as follows, respectively:

$$\dot{V}_B = \alpha^2 \dot{V}_{f1} + \alpha \dot{V}_{f2} + \dot{V}_{f0} = \alpha^2 (\dot{V}_{fa[0]} - Z_1 \dot{I}_{f1}) - \alpha Z_1 \dot{I}_{f1} - Z_0 \dot{I}_{f1} = \dot{V}_{fb[0]} - \dot{V}_{fa[0]} \frac{Z_0 - Z_1}{2Z_1 + Z_0 + 3R_f},$$

and

$$\dot{V}_C = \alpha \dot{V}_{f1} + \alpha^2 \dot{V}_{f2} + \dot{V}_{f0} = \dot{V}_{fc[0]} - \dot{V}_{fa[0]} \frac{Z_0 - Z_1}{2Z_1 + Z_0 + 3R_f}.$$

Next, the CR may be expressed as:

$$CR = \frac{\left| \dot{V}_{fb[0]} - \dot{V}_{fa[0]} \dfrac{Z_0 - Z_1}{2Z_1 + Z_0 + 3R_f} \right|}{\left| \dot{V}_{fc[0]} - \dot{V}_{fa[0]} \dfrac{Z_0 - Z_1}{2Z_1 + Z_0 + 3R_f} \right|} = f(Z_1, Z_2, R_f).$$

Although none of the three parameters $Z_1$, $Z_0$ and $R_f$ in the above equation is known, a relationship between the CR value and the ratio of the magnitudes of the B-phase voltage and the C-phase voltage satisfies a graph shown in Fig.6 according to experiences, that is, the CR value is within a range of [0.67, 1.05]. As a result, the CR may be assumed as a fixed value within the range of [0.67, 1.05] in this case. Then we can obtain $FC = CR \times FB$.

For example, it may assume that the CR is fixed at 1.0, and accordingly $FC = FB$. Furthermore, $FC = 1$ under an assumption of $FB = 1$.

Next, a process for estimating the negative-sequence impedance at the earth fault detection device in the step S520 will be described below.

Research shows that, the negative-sequence impedance $Z_2$ is determined by the distribution network itself and nearly not affected by a shunt capacitance, the earth resistance of the earth fault and the neutral earthing types. Therefore, there is a stable relationship between the negative-sequence current and the negative-sequence voltage.

The relationship between the negative-sequence current and the negative-sequence voltage depends on a negative-sequence loop impedance Z2 behind the earth fault detection device. The negative-sequence impedance would be calculated according to three different positions of the earth fault detection device: a grid device, the decentralized generating devices and the load devices.

Therefore, in the step S520, an exact position of the earth fault detection device in the distribution network is needed to be determined at first, then the negative-sequence impedance at the earth fault detection device is differently according to the exact position of the earth fault detection device.

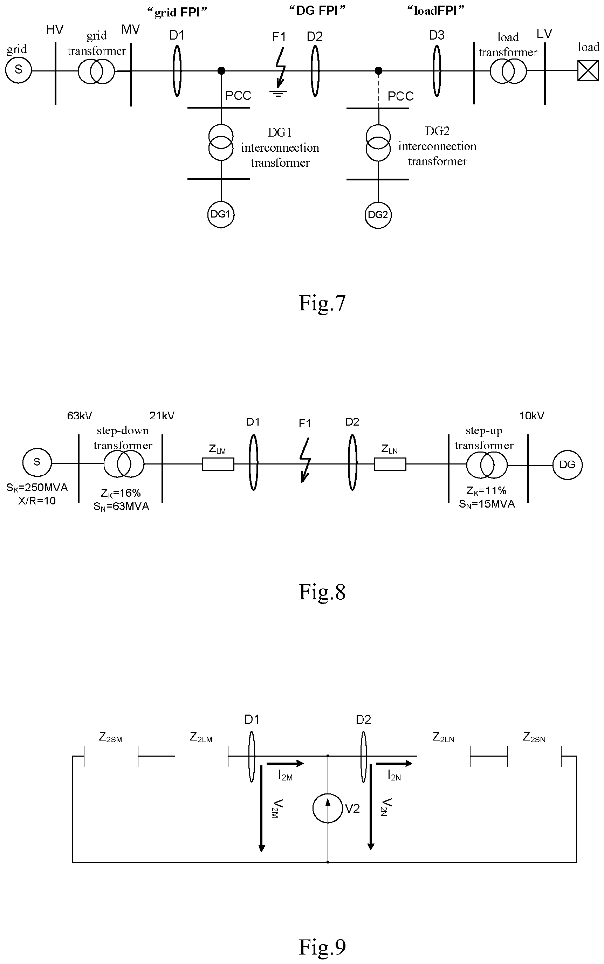

As illustrated in Fig.7, F1 is an A-phase earth fault, there are several devices with a earth fault detection function, namely the earth fault detection devices, such as D1, D2 and D3, normally more than two decentralized generating devices are interconnected in each distribution feeder, and only two decentralized generating devices DGs are illustrated in Fig.7, which represent the nearest and furthest decentralized generating devices to a substation (a high voltage-medium voltage step-down transformer) in the distribution network, respectively.

During the F1 fault, the D1 would detect a forward fault, and the negative-sequence impedance $Z_2$ detected by D1 is decided by a grid internal impedance; the D2 would detect a backward fault, and the negative-sequence impedance $Z_2$ detected by D2 is decided by a DG internal impedance; and the D3 would detect a backward fault, and the negative-sequence impedance $Z_2$ detected by D1 is decided by a load impedance.

Fig.8 schematically illustrates a connection diagram for the earth fault detection device D1, which is far away from the decentralized generating device and loads while locates at a medium voltage side in the distribution network, and the earth fault detection device D2, which is near to the decentralized generating device while locates at the medium voltage side in the distribution network.

Fig.9 schematically illustrates a negative-sequence network for the earth fault detection device D1, which is far away from the decentralized generating device and loads while locates at the medium voltage side in the distribution network, and the earth fault detection device D2, which is near to the decentralized generating device while locates at the medium voltage side in the distribution network.

$Z_{2SM}$ is a negative-sequence source impedance at the grid side, including a (sub)transmission area impedance (that is, a grid system impedance before the step-down transformer) and a leakage impedance of the step-down transformer; $Z_{2LM}$ is a negative-sequence impedance of lines or cables between the step-down transformer and the device D1; $I_{2M}$ is a negative-sequence current measured by the device D1; $V_{2M}$ is a negative-sequence voltage measured by the device D1; $V2$ is a negative-sequence voltage source at the fault position; $Z_{2SN}$ is a negative-sequence source impedance at the decentralized generating device side, including a generator impedance and a leakage impedance of a step-up transformer; $Z_{2LN}$ is a negative-sequence impedance of lines or cables between the step-up transformer and the device D2; $I_{2N}$ is a negative-sequence current measured by the device D2, $V_{2N}$ is a negative-sequence voltage measured by the device D2.

1. Earth Fault Detection Device D1

For the earth fault detection device D1, the process for estimating the negative-sequence impedance at the earth fault detection device may comprise: estimating a grid system impedance at the high voltage side of the distribution network; estimating a transformer impedance of the step-down transformer between the high voltage side and the medium voltage side in the distribution network; referencing the estimated grid system impedance and the transformer impedance to the medium voltage side to obtain a grid negative-sequence impedance; estimating a cable negative-sequence impedance from the step-down transformer to the earth fault detection device; and adding the grid negative-sequence impedance to the cable negative-sequence impedance.

For the earth fault detection device D1, the negative-sequence current and the negative-sequence voltage measured by it satisfy a following relationship:

$$\dot{V}_{2M} = -\dot{I}_{2M} \cdot Z_{2M} = -\dot{I}_{2M} \cdot (Z_{2SM} + Z_{2LM}) = -\dot{I}_{2M} \cdot Z_{2M}.$$

As described above, $Z_{2SM}$ includes the (sub)transmission area impedance (that is, the grid system impedance before the step-down transformer) and the leakage impedance of the step-down transformer, so the impedance at the high voltage (HV) side may be calculated by:

$$Z_{2SM\_HV} = \frac{(V_K)^2}{S_k} + \frac{(V_N)^2}{S_N} \times Z_K,$$

where $V_K$ is the voltage at the high voltage side in the distribution network before the step-down transformer, $S_k$ is a short-circuit capacity of the high voltage side in the distribution network before the step-down transformer; $S_N$ is a rated power of the step-down transformer; and $Z_K$ is a short-circuit impedance percentage of the step-down transformer.

Further, the impedance of the high voltage (HV) side may be referenced to an impedance of the medium voltage (MV) side as follows:

$$Z_{2SMV} = \frac{Z_{2SM\_HV}}{(V_K/V_N)^2},$$

where $V_N$ is the voltage at the medium voltage side in the distribution network after the step-down transformer.

Assumed that: the voltage at the high voltage side in the distribution network before the step-down transformer is 63kV and the short-circuit capacity is 250MVA, the voltage at the medium voltage side in the distribution network after the step-down transformer is 21kV and the rated power of the step-down transformer is 63MVA, and the short-circuit impedance percentage of the step-down transformer is 16%. Therefore the impedance of the high voltage (HV) side and the impedance of the medium voltage (MV) side may be calculated as follows.

$$Z_{2SM\_HV} = \frac{(63kV)^2}{250MVA} + \frac{(63kV)^2}{63MVA} \times 16\% = 25.956\Omega \xrightarrow{X/R=10} (2.57 + 25.7j)\Omega,$$

and

$$Z_{2SM} = \frac{(2.57 + 25.7j)\Omega}{(63kV / 21kV)^2} = (0.29 + 2.86j)\Omega,$$

where $X/R$ represents a reactance/resistance ratio, and for example may be selected as $X/R$=10 according to experiences.

The negative-sequence impedance $Z_{2LM}$ of lines or cables between the step-down transformer and the device D1 may be calculated by $Z_{2LM} = z_{l2} \cdot L$, where $z_{l2}$ is a negative-sequence impedance per kilometer, for example, 0.2Ω of a resistance per kilometer while 0.766mH of an inductance per kilometer.

If the earth fault detection device D1 at the grid side is installed just downstream to the substation, then the negative-sequence impedance at the earth fault detection device D1 may be calculated by $Z_{2M} = Z_{2SM} + Z_{2LM} = Z_{2SM}$. Base on the above assumptions still, then,

$$\varphi_{Z2M} = a\,tan\left(\frac{2.86}{0.29}\right) = 84°.$$

On the other hand, if the earth fault detection device D1 at the grid side is installed very far away from the substation, because an economical longest distance from the substation to the load will usually not exceed 30km, for such earth fault detection device D1 installed with the limit long distance, its negative-sequence impedance may be calculated by:

$$Z_{2M} = Z_{2SM} + Z_{2LM} = Z_{2SM} + z_{l2} \cdot 30.$$

Based on above assumptions still, then

$$Z_{2M} = Z_{2SM} + Z_{2LM} = Z_{2SM} + z_{l2} \cdot 30 = 0.29 + 2.86j + (0.2 + 0.24j) \times 30 = (6.29 + 10.06j)\Omega$$

$$\varphi_{Z2M} = a\tan\left(\frac{10.06}{6.29}\right) = 58°.$$

A medium value between the above two limit situations may be selected as the angle of the negative-sequence impedance of the earth fault detection device D1 at the grid side. For example, the angle of the negative-sequence impedance at the earth fault detection device may be estimated as a first predetermined angle, such as 70°.

2. Earth Fault Detection Device D2

For the earth fault detection device D2, its negative-sequence impedance is calculated also based on the equivalent diagram illustrated in Fig.9, and the process for estimating the negative-sequence impedance at the earth fault detection device D2 may comprise: estimating a generating device impedance of the decentralized generating device; estimating a transformer impedance of a step-up transformer between the decentralized generating device and the medium voltage side in the distribution network; referencing the estimated generating device impedance and the transformer impedance to the medium voltage side to obtain a generating device negative-sequence impedance; estimating a cable negative-sequence impedance from the step-up transformer to the earth fault detection device; and adding the generating device negative-sequence impedance to the cable negative-sequence impedance.

The negative-sequence voltage and the negative-sequence current measured by the earth fault detection device D2 satisfy a following relationship:

$$\dot{V}_{2N} = \dot{I}_{2N} \cdot Z_{2N} = \dot{I}_{2N} \cdot (Z_{2SN} + Z_{2LN}) = \dot{I}_{2N} \cdot Z_{2N}.$$

The negative-sequence impedance $Z_{2N}$ at the earth fault detection device D2 may be estimated similarly. In particular,

$$Z_{2SN\_DG} = \frac{(V_{DG})^2}{S_{DG}} + \frac{(V_N)^2}{S_N} \times Z_K,$$

where $V_{DG}$ is the voltage of the decentralized generating device, $S_{DG}$ is a short-circuit capacity of the decentralized generating device; $S_N$ is a rated power of the step-up transformer; and $Z_K$ is a short-circuit impedance percentage of the step-up transformer.

Further, the impedance of the decentralized generating device may be referenced to an impedance of the medium voltage (MV) side as follows:

$$Z_{2SN} = \frac{Z_{2SN\_DG}}{(V_{DG}/V_N)^2}.$$

Further, the negative-sequence impedance $Z_{2LN}$ of the cables between the step-up transformer and the earth fault detection device D2 may be calculated similarly to the $Z_{2LM}$. Next, the angle of the negative-sequence impedance $Z_{2N}$ at the earth fault detection device D2 may be estimated correspondingly.

For example, the angle of the negative-sequence impedance $Z_{2N}$ at the earth fault detection device D2 may be also within a range of [58°, 84°]. As another example, the angle of the negative-sequence impedance $Z_{2N}$ at the earth fault detection device D2 may be estimated as a second predetermined angle, for example 70° too.

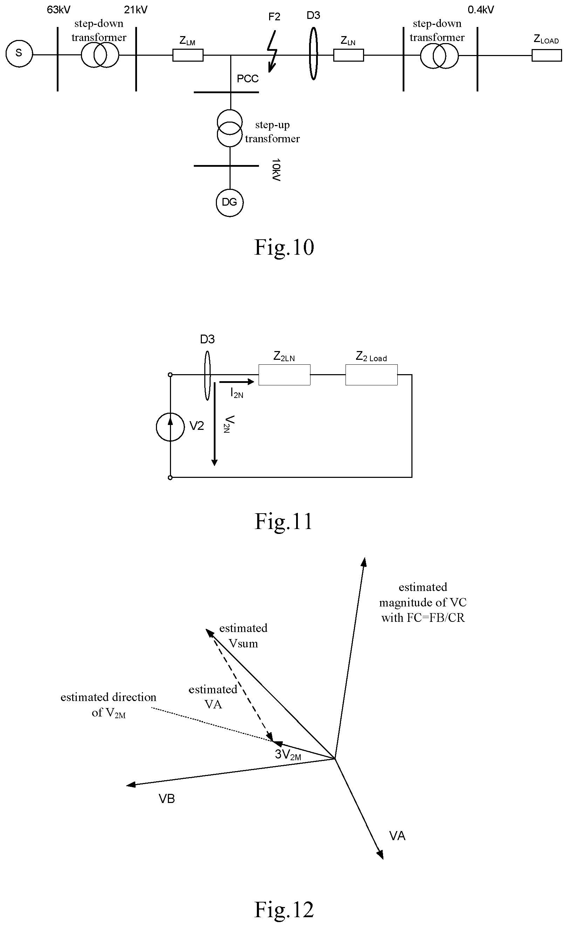

Fig.10 schematically illustrates a connection diagram for the earth fault detection device D3 which is near to the loads while locates at the medium voltage side in the distribution network.

Fig.11 schematically illustrates an equivalent diagram of the negative-sequence network for the earth fault detection device D3 which is near to the loads while locates at the medium voltage side in the distribution network.

$Z_{2LN}$ is a negative-sequence impedance of cables between the earth fault detection device D3 and a load; $Z_{2\_Load}$ is a negative-sequence impedance of the load; $I_{2N}$ is a negative-sequence current measured by the earth fault detection device D3; and $V_{2N}$ is a negative-sequence voltage measured by the earth fault detection device D3.

3. Earth Fault Detection Device D3

The negative-sequence voltage and the negative-sequence current measured by the earth fault detection device D3 satisfy a following relationship:

$$\dot{V}_{2N} = \dot{I}_{2N} \cdot Z_{2N} = \dot{I}_{2N} \cdot (Z_{2\_Load} + Z_{2LN})_{.}$$

In a case that the earth fault detection device D3 is installed just adjacent to the load, $\dot{V}_{2N} = \dot{I}_{2N} \cdot Z_{2\_Load}$.

On the other hand, in a case that the earth fault detection device D3 is far away from the load, the negative-sequence impedance of cables between the earth fault detection device D3 and the load may be calculated similarly to above.

Further, the negative-sequence impedance at the earth fault detection device D3 may be estimated according to a rated power factor of the load. For example, the angle of the negative-sequence impedance at the earth fault detection device D3 may be estimated as a third predetermined angle, for example 26°.

Next, the estimation of the A-phase voltage in the step S530 would be described.

**Estimation of A-Phase Voltage**

The A-phase voltages at the earth fault detection device D1, the earth fault detection device D2 and the earth fault detection device D3 would be estimated with the negative-sequence impedances calculated above.

1. Earth Fault Detection Device D1

As described above, the negative-sequence voltage at the D1 may be expressed as:

$$\dot{V}_{2M} = -\dot{I}_{2M} \cdot Z_{2M} \qquad . \qquad\qquad (8)$$

Correspondingly, the angle of the negative-sequence voltage at the D1 may be expressed as: $\varphi_{V2M} = \varphi_{I2M} + 180° + \varphi_{Z2M}$.

The negative-sequence current at the D1 may be expressed by three phase currents:

$$\dot{I}_{2M} = (\dot{I}_A + \alpha^2 \cdot \dot{I}_B + \alpha \cdot \dot{I}_C)/3 .$$

Also, the negative-sequence voltage at the D1 may also be expressed by the three phase voltages:

$$3 \cdot \dot{V}_{2M} = \dot{V}_A + \alpha^2 \cdot \dot{V}_B + \alpha \cdot \dot{V}_C .$$

Let $\dot{V}_{sum} = \alpha^2 \cdot \dot{V}_B + \alpha \cdot \dot{V}_C$ in order to simplify the expression.

Because the VPIS may provide the accurate angles of the A-phase voltage, the B-phase voltage and the C-phase voltage, then $\dot{V}_{sum} = \alpha^2 \cdot FB \cdot e^{j\varphi B} + \alpha \cdot FC \cdot e^{j\varphi C}$.

The angle of the $\dot{V}_{2M}$ is known, and both the magnitude and angle of the $\dot{V}_{sum}$ are known, therefore it may obtain an expression as follows:

$$tan(\varphi_{V2M}) = \frac{\mathrm{Im}\,Vsum + \mathrm{Im}\,Va}{\mathrm{Re}\,Vsum + \mathrm{Re}\,Va} = \frac{\mathrm{Im}\,Vsum + \mathrm{Re}\,Va \cdot tan(\varphi_A)}{\mathrm{Re}\,Vsum + \mathrm{Re}\,Va} .$$

Correspondingly, the real part and the imaginary part of the A-phase voltage $\dot{V}_A$ may be calculated as:

$$\mathrm{Re}\,Va = \frac{-\mathrm{Im}\,Vsum + tan(\varphi_{V2M}) \cdot \mathrm{Re}\,Vsum}{tan(\varphi_A) - tan(\varphi_{V2M})} ,$$

and

Im$Va$ = Re$Va \cdot \tan(\varphi_A)$, respectively.

Fig.12 illustrates the magnitude of the estimated A-phase voltage. In Fig.12, an extension line may be drawn in a direction of $\dot{V}_A$ starting from an endpoint of $\dot{V}_{sum}$, until this extension line intersects with an extension line of $\dot{V}_{2M}$, and a length of the extension line drawn in the direction of $\dot{V}_A$ is the magnitude FA of the A-phase voltage.

2. Earth Fault Detection Device D2

As described above, the negative-sequence voltage at the D2 may be expressed as: $\dot{V}_{2N} = \dot{I}_{2N} \cdot Z_{2N}$.

Correspondingly, the angle of the negative-sequence voltage at the D2 may be expressed as: $\varphi_{V2N\_actual} = \varphi_{I2N} + \varphi_{Z2N}$.

The negative-sequence voltage is still expressed by the above equation (8) because the fault position can not be estimated before the fault occurs, thus the angle of the negative-sequence voltage may be expressed by:

$$\varphi_{V2N\_calculated} = \varphi_{I2N} + \varphi_{Z2N} + 180°.$$

Similarly, the negative -sequence current at the D2 may be expressed by three phase currents:

$$\dot{I}_{2N} = (\dot{I}_A + \alpha^2 \cdot \dot{I}_B + \alpha \cdot \dot{I}_C)/3.$$

Also, the negative-sequence voltage at the D2 may also be expressed by the three phase voltages:

$$3 \cdot \dot{V}_{2N} = \dot{V}_A + \alpha^2 \cdot \dot{V}_B + \alpha \cdot \dot{V}_C.$$

Let $\dot{V}_{sum} = \alpha^2 \cdot \dot{V}_B + \alpha \cdot \dot{V}_C$ in order to simplify the expression.

Similarly, it can obtain an expression as follows:

$$tan(\varphi_{V2N}) = \frac{\mathrm{Im}Vsum + \mathrm{Im}Va}{\mathrm{Re}Vsum + \mathrm{Re}Va} = \frac{\mathrm{Im}Vsum + \mathrm{Re}Va \cdot \tan(\varphi_A)}{\mathrm{Re}Vsum + \mathrm{Re}Va}.$$

Correspondingly, the real part and the imaginary part of the A-phase voltage $\dot{V}_A$ may be calculated as:

$$\mathrm{Re}Va = \frac{-\mathrm{Im}Vsum + tan(\varphi_{V2N}) \cdot \mathrm{Re}Vsum}{tan(\varphi_A) - tan(\varphi_{V2N})},$$

and

Im$Va$ = Re$Va \cdot \tan(\varphi_A)$, respectively.

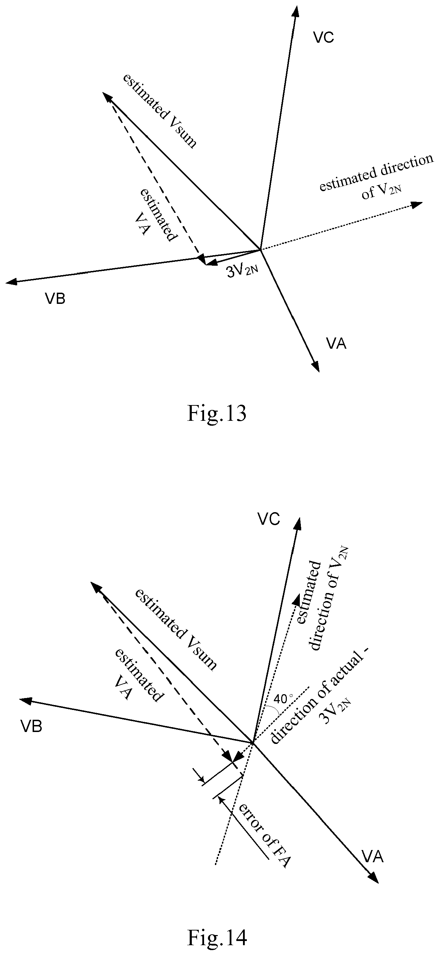

Fig.13 illustrates the magnitude of the estimated A-phase voltage. In Fig. 13, an extension line may be drawn in a direction of $\dot{V}_A$ starting from an endpoint of $\dot{V}_{sum}$, until this extension line intersects with an extension line of $\dot{V}_{2N}$, and a length of the extension line drawn in the direction of $\dot{V}_A$ is the magnitude FA of the A-phase voltage.

3. Earth Fault Detection Device D3

Because the angle of the negative-sequence impedance at the earth fault detection device D3 is normally decided by a system power factor and is generally less than 30°, if the above equation (8) is still used, the estimated angle of the -$V_{2N}$ may shift around 40°.

As the magnitude of the $V_{2N}$ is usually a small value compared to the phase voltage during the single-phase earth fault, which causes that the $\dot{V}_{sum}$ and $\dot{V}_A$ are nearly 180° out of phase. Therefore the 40° of angle shift will only cause a small error of the FA estimation.

Therefore, it can obtain an expression as follows similarly:

$$tan(\varphi_{V2N}) = \frac{\mathrm{Im}\,Vsum + \mathrm{Im}\,Va}{\mathrm{Re}\,Vsum + \mathrm{Re}\,Va} = \frac{\mathrm{Im}\,Vsum + \mathrm{Re}\,Va \cdot tan(\varphi_A)}{\mathrm{Re}\,Vsum + \mathrm{Re}\,Va} \quad .$$

Correspondingly, the real part and the imaginary part of the A-phase voltage $\dot{V}_A$ may be calculated as:

$$\mathrm{Re}\,Va = \frac{-\mathrm{Im}\,Vsum + tan(\varphi_{V2N}) \cdot \mathrm{Re}\,Vsum}{tan(\varphi_A) - tan(\varphi_{V2N})} \quad ,$$

and
$\mathrm{Im}\,Va = \mathrm{Re}\,Va \cdot tan(\varphi_A)$, respectively.

Fig.14 illustrates the magnitude of the estimated A-phase voltage. In Fig.14, an extension line may be drawn in a direction of $\dot{V}_A$ starting from an endpoint of $\dot{V}_{sum}$, until this extension line intersects with an extension line of $\dot{V}_{2N}$, and a length of the extension line drawn in the direction of $\dot{V}_A$ is the magnitude FA of the A-phase voltage.

In conclusion, following equations may be used in the Mode 2:

$$\mathrm{Re}\,Vb = FB \cdot \cos\varphi_B, \mathrm{Im}\,Vb = FB \cdot \sin\varphi_B,$$

$$\mathrm{Re}\,Vc = CR \cdot FB \cdot \cos\varphi_C, \mathrm{Im}\,Vc = CR \cdot FB \cdot \sin\varphi_C,$$

$$\dot{V}_{sum} = \alpha^2 \cdot \dot{V}_B + \alpha \cdot \dot{V}_C,$$

$$\mathrm{Re}\,Va = \frac{-\mathrm{Im}\,Vsum + tan(\varphi_{V2}) \cdot \mathrm{Re}\,Vsum}{tan(\varphi_A) - tan(\varphi_{V2})},$$

and

$$\mathrm{Im}\,Va = \mathrm{Re}\,Va \cdot tan(\varphi_A),$$

where

$$\varphi_{V2} = \varphi_{I2} + 180° + \varphi_{Z2}.$$

Thus the angle of the residual voltage may be calculated by:

$$\varphi_{VR} = a\tan\left(\frac{ImVa + ImVb + ImVc}{\mathrm{Re}\,Va + \mathrm{Re}\,Vb + \mathrm{Re}\,Vc}\right).$$

After the angle of the residual voltage is calculated, the direction of the single-phase earth fault may be determined with at least one of the above equations (1)-(6) according to the different neutral earthing type in the distribution network.

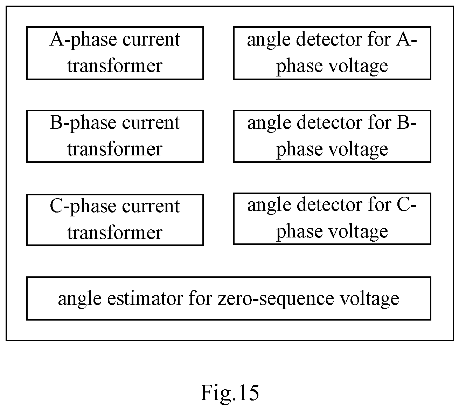

Fig.15 illustrates a device for estimating an angle of a zero-sequence voltage when a single-phase earth fault occurs in a distribution network according to the embodiments of the present disclosure, which may be included in the earth fault detection devices D1-D3.

The device for estimating the angle of the zero-sequence voltage according to the embodiments of the present disclosure comprises: an angle detector for an A-phase voltage, an angle detector for a B-phase voltage and an angle detector for a C-phase voltage; and an angle estimator for a zero-sequence voltage for estimating the angle of the zero-sequence voltage when the single-phase earth fault occurs in the distribution network with angles of respective phase voltages detected by the angle detector for the A-phase voltage, the angle detector for the B-phase voltage and the angle detector for the C-phase voltage, according to a neutral earthing type of the distribution network.

As described above, the angle estimator for the zero-sequence voltage may set a magnitude of a B-phase voltage as a predetermined reference value, estimate an A-phase voltage and a C-phase voltage by using the magnitude of the B-phase voltage and the angles of the A-phase voltage, the B-phase voltage, and the C-phase voltage, and calculate the angle of the zero-sequence voltage by using the B-phase voltage and the estimated A-phase voltage and the estimated C-phase voltage.

In a case that the neutral earthing type of the distribution network is a neutral resonant earthing or a neutral isolated earthing, the angle estimator for the zero-sequence voltage calculates real parts and imaginary parts of the B-phase, the C-phase, and the A-phase by following equations:

$$\mathrm{Re}Vb = FB \cdot \cos\varphi_B, \mathrm{Im}Vb = FB \cdot \sin\varphi_B,$$

$$\mathrm{Re}Vc = \frac{k3}{k4}, \quad \mathrm{Im}Vc = \mathrm{Re}Vc \cdot \tan(\varphi_C),$$

$$\mathrm{Re}Va = k1 \cdot \mathrm{Re}Vc + k2[, \quad \mathrm{Im}Va = \mathrm{Re}Va \cdot \tan(\varphi_A)_{.}$$

Furthermore, the device for estimating the angle of the zero-sequence voltage according the embodiments of the present disclosure may further comprise an A-phase current transformer, a B-phase current transformer and a C-phase current transformer.

In a case that the neutral earthing type of the distribution network is a neutral solidly earthing, the angle estimator for the zero-sequence voltage determines a magnitude $FC$ of the C-phase voltage as a predetermined multiple of the magnitude $FB$ of the B-phase voltage, estimates an angle of a negative-sequence impedance at an earth fault detection device, calculates an angle of a negative-sequence current according to three phase currents provided by the A-phase current transformer, the B-phase current transformer and the C-phase current transformer, and estimates the real parts and the imaginary parts of the B-phase voltage, the C-phase voltage and the A-phase voltage according to following equations:

$$\mathrm{Re}Vb = FB \cdot \cos\varphi_B, \mathrm{Im}Vb = FB \cdot \sin\varphi_B,$$

$$\mathrm{Re}Vc = \mathrm{CR} \cdot FB \cdot \cos\varphi_C, \mathrm{Im}Vc = \mathrm{CR} \cdot FB \cdot \sin\varphi_C,$$

$$\dot{V}_{sum} = \alpha^2 \cdot \dot{V}_B + \alpha \cdot \dot{V}_C,$$

$$\mathrm{Re}Va = \frac{-\mathrm{Im}Vsum + tan(\varphi_{V2}) \cdot \mathrm{Re}Vsum}{tan(\varphi_A) - tan(\varphi_{V2})},$$

and

$$\mathrm{Im}Va = \mathrm{Re}Va \cdot \tan(\varphi_A).$$

Thus the angle estimator for the zero-sequence voltage may calculate the angle of the residual voltage by:

$$\varphi_{VR} = a\tan\left(\frac{ImVa + ImVb + ImVc}{\mathrm{Re}Va + \mathrm{Re}Vb + \mathrm{Re}Vc}\right).$$

Preferably, the earth fault detection device may further comprise a zero-sequence current transformer for measuring the zero-sequence current in the three-phase distribution network directly, which may eliminate a difference current caused by a slightly unmatched among the three separate current transformers, especially in a grid system in which a high resistence earth fault occurs or the neutral is not solidly earthed. Thus the directional detection of the earth fault is more accurate.

With the method and device for estimating the angle of the zero-sequence voltage when the single-phase earth fault occurs in the distribution network according to the embodiments of the present disclosure, the angle of the zero-sequence voltage may be estimated with the angles of the three phase voltages provided by the existing VPIS, which removes requirements for equipping expensive voltage transformers, so that the detection for the single-phase earth fault is simpler and easier, and the cost of the earth fault detection device is reduced.

It should be noted that individual drawings only show parts related to the embodiments of the present disclosure for the sake of conciseness and clarity, but those skilled in the art should understand that the device and apparatus shown in the drawings may include other necessary units.

Above are only specific embodiments of the present disclosure, and the scope of the present disclosure is not so limited. Any ordinary person skilled in the art may easily make various modifications and alterations, and it is intended that all these modifications and alterations should be encompassed within the appended claims. Therefore, the scope of the present disclosure should be defined by the appended claims.

## Claims

1. A method for estimating a phase angle of a zero-sequence voltage when a single-phase earth fault occurs in a distribution network, the distribution network comprising an A-phase having the earth fault, a B-phase and a C-phase, the method comprising: determining (S320) a neutral earthing type of the distribution network; **characterized in that** the method comprises:

   detecting (S310) a phase angle $\varphi_A$ of an A-phase voltage, a phase angle $\varphi_B$ of a B-phase voltage and a phase angle $\varphi_C$ of a C-phase voltage;
   setting (S410) a magnitude *FB* of the B-phase voltage as a predetermined reference value;
   estimating (S420) the A-phase voltage and the C-phase voltage by using the magnitude of the B-phase voltage, the phase angle $\varphi_A$ of the A-phase voltage, the phase angle $\varphi_B$ of the B-phase voltage and the phase angle $\varphi_C$ of the C-phase voltage, based on the neutral earthing type of the distribution network; and
   calculating (S430) the phase angle of the zero-sequence voltage by using the B-phase voltage and the estimated A-phase voltage and the estimated C-phase voltage.

2. The method for estimating a phase angle of a zero-sequence voltage of claim 1, **characterized in that** the neutral earthing type of the distribution network is a neutral resonant earthing or a neutral isolated earthing, the three phase voltages satisfy equations as follows:

$$
\begin{cases}
\mathrm{Re}Va - \mathrm{Re}Vb = -0.5 \cdot (\mathrm{Re}Vb - \mathrm{Re}Vc) - \dfrac{\sqrt{3}}{2} \cdot (\mathrm{Im}Vb - j \cdot \mathrm{Im}Vc) \\[2mm]
\mathrm{Im}Va - \mathrm{Im}Vb = \dfrac{\sqrt{3}}{2} \cdot (\mathrm{Re}Vb - \mathrm{Re}Vc) - 0.5 \cdot (\mathrm{Im}Vb - \mathrm{Im}Vc) \\[2mm]
\mathrm{Re}Vb - \mathrm{Re}Vc = -0.5 \cdot (\mathrm{Re}Vc - \mathrm{Re}Va) - \dfrac{\sqrt{3}}{2} \cdot (\mathrm{Im}Vc - j \cdot \mathrm{Im}Va) \\[2mm]
\mathrm{Im}Vb - \mathrm{Im}Vc = \dfrac{\sqrt{3}}{2} \cdot (\mathrm{Re}Vc - \mathrm{Re}Va) - 0.5 \cdot (\mathrm{Im}Vc - \mathrm{Im}Va)
\end{cases},
$$

   wherein Re*Va* is the real part of the A-phase voltage, Im *Va* is the imaginary part of the A-phase voltage, Re*Vb* is the real part of the B-phase voltage, *ImVb* is the imaginary part of the B-phase voltage, *ReVc* is the real part of the C-phase voltage, Im*Vc* is the imaginary part of the C-phase voltage.

3. The method for estimating a phase angle of a zero-sequence voltage of claim 2, **characterized in that** the real part and the imaginary part of the B-phase are:

$$\mathrm{Re}Vb = FB \cdot \cos\varphi_B, \mathrm{Im}Vb = FB \cdot \sin\varphi_B,$$

and the real parts and the imaginary parts of the A-phase voltage and the C-phase voltage are estimated by using the magnitude of the B-phase voltage, the phase angle $\varphi_B$ of the B-phase voltage, the phase angle $\varphi_A$ of the A-phase voltage and the phase angle $\varphi_C$ of the C-phase voltage:

$$\mathrm{Re}\,Vc = \frac{k3}{k4}, \quad \mathrm{Im}\,Vc = \mathrm{Re}\,Vc \cdot \tan(\varphi_C),$$

$$\mathrm{Re}\,Va = k1 \cdot \mathrm{Re}\,Vc, \quad \mathrm{Im}\,Va = \mathrm{Re}\,Va \cdot \tan(\varphi_A);$$

wherein

$$\begin{cases} k1 = \dfrac{-\dfrac{\sqrt{3}}{2} + 0.5 \cdot \tan(\varphi_C)}{\tan(\varphi_A)} \\[4mm] k2 = \dfrac{\dfrac{\sqrt{3}}{2} \cdot \cos\varphi_B + 0.5 \cdot \sin\varphi_B}{\tan(\varphi_A)} FB \\[4mm] k3 = FB\sin\varphi_B + \dfrac{\sqrt{3}}{2} \cdot k2 - 0.5 \cdot k2 \cdot \tan(\varphi_A) \\[4mm] k4 = \tan(\varphi_C) + \dfrac{\sqrt{3}}{2} - k1 \cdot \dfrac{\sqrt{3}}{2} - 0.5\tan(\varphi_C) + 0.5 \cdot k1 \cdot \tan(\varphi_A) \end{cases}.$$

4. The method for estimating a phase angle of a zero-sequence voltage of claim 1, **characterized in that** the neutral earthing type of the distribution network is a neutral solidly earthing, said estimating the A-phase voltage and the C-phase voltage comprises:

   estimating (S510) a magnitude *FC* of the C-phase voltage by using the magnitude *FB* of the B-phase voltage;
   estimating (S520) a negative-sequence impedance at the earth fault detection device; and
   estimating (S530) the A-phase voltage by using the phase angle $\varphi_A$ of the A-phase voltage, the phase angle $\varphi_B$ of the B-phase voltage and the phase angle $\varphi_C$ of the the C-phase voltage , the magnitudes of the B-phase voltage and the C-phase voltage, and the estimated negative-sequence impedance at the earth fault detection device.

5. The method for estimating a phase angle of a zero-sequence voltage of claim 4, **characterized in that** said estimating the magnitude of the C-phase voltage comprises:

   estimating a proportion relationship between the magnitude of the B-phase voltage and the magnitude of the C-phase voltage; and
   calculating a magnitude of the C-phase voltage by using the magnitude of the B-phase voltage and the proportion relationship.

6. The method for estimating a phase angle of a zero-sequence voltage of claim 4, **characterized in that** said estimating the negative-sequence impedance at the earth fault detection device comprises:

   determining an exact position of the earth fault detection device in the distribution network; and
   estimating the negative-sequence impedance at the earth fault detection device differently according to the exact position of the earth fault detection device.

7. The method for estimating a phase angle of a zero-sequence voltage of claim 6, **characterized in that** the earth fault detection device is far away from the decentralized generating device and loads, and locates at a medium voltage side in the distribution network, said estimating the negative-sequence impedance at the earth fault detection device comprises:

estimating a grid system impedance at a high voltage side of the distribution network;
estimating a transformer impedance of a step-down transformer between the high voltage side and the medium voltage side in the distribution network;
referencing the estimated grid system impedance and the transformer impedance to the medium voltage side to obtain a grid negative-sequence impedance;
estimating a cable negative-sequence impedance from the step-down transformer to the earth fault detection device; and
adding the grid negative-sequence impedance to the cable negative-sequence impedance.

8. The method for estimating a phase angle of a zero-sequence voltage of claim 6, **characterized in that** the earth fault detection device is near to the decentralized generating device and locates at a medium voltage side in the distribution network, said estimating the negative-sequence impedance at the earth fault detection device comprises:

estimating a generating device impedance of the decentralized generating device;
estimating a transformer impedance of a step-up transformer between the decentralized generating device and the medium voltage side in the distribution network;
referencing the estimated generating device impedance and the transformer impedance to the medium voltage side to obtain a generating device negative-sequence impedance;
estimating a cable negative-sequence impedance from the step-up transformer to the earth fault detection device; and
adding the generating device negative-sequence impedance to the cable negative-sequence impedance.

9. The method for estimating a phase angle of a zero-sequence voltage of claim 4, **characterized in that** said estimating the A-phase voltage comprises:

calculating a phase angle of the negative-sequence voltage by using the estimated angle of the negative-sequence impedance at the earth fault detection device and the phase angle of the negative-sequence current; and
estimating a real part and an imaginary part of the A-phase voltage by using the phase angle $\varphi_A$ of the A-phase voltage, the phase angle $\varphi_B$ of the B-phase voltage and the phase angle $\varphi_C$ of the C-phase voltage, the magnitudes of the B-phase voltage and the C-phase voltage, and the phase angle of the negative-sequence voltage.

10. The method for estimating a phase angle of a zero-sequence voltage of claim 9, **characterized in that** the real part and the imaginary part of the A-phase voltage are as follows:

$$\mathrm{Re}\,Va = \frac{-\mathrm{Im}\,Vsum + tan(\varphi_{V2}) \cdot \mathrm{Re}\,Vsum}{tan(\varphi_A) - tan(\varphi_{V2})}$$

$$\mathrm{Im}\,Va = \mathrm{Re}\,Va \cdot tan(\varphi_A)\,,$$

wherein Re$Vsum$ is a real part of $\dot{V}_{sum}$, Im$Vsum$ is an imaginary part of the $\dot{V}_{sum}$,

$$\dot{V}_{sum} = \alpha^2 \cdot FB \cdot e^{j\varphi_B} + \alpha \cdot FC \cdot e^{j\varphi_C}\,, \quad \alpha = -0.5 + j\frac{\sqrt{3}}{2}\,;$$

$\varphi_{V2} = \varphi_{I2} + 180° + \varphi_{Z2}$, $\varphi_{I2}$ is the phase angle of the negative-sequence current, $\varphi_{Z2}$ is the phase angle of the negative-sequence impedance, and $\varphi_{V2}$ is the phase angle of the negative-sequence voltage.

11. A device for estimating a phase angle of a zero-sequence voltage when a single-phase earth fault occurs in a distribution network, the distribution network comprising an A-phase having the earth fault, a B-phase and a C-phase, the device **characterized by** comprising:

an angle detector configured to detect a phase angle $\varphi_A$ of an A-phase voltage, an angle detector configured to detect a phase angle $\varphi_B$ of a B-phase voltage and an angle detector configured to detect a phase angle $\varphi_C$ of a C-phase voltage; and

an angle estimator configured to set a magnitude *FB* of the B-phase voltage as a predetermined reference value, to estimate the A-phase voltage and the C-phase voltage by using the magnitude of the B-phase voltage, the phase angle $\varphi_A$ of the A-phase voltage, the phase angle $\varphi_B$ of the B-phase voltage and the phase angle $\varphi_C$ of the C-phase voltage, based on a neutral earthing type of the distribution network; and to calculate the phase angle of the zero-sequence voltage by using the B-phase voltage and the estimated A-phase voltage and the estimated C-phase voltage.

12. The device for estimating a phase angle of a zero-sequence voltage of claim 11, wherein the angle estimator is configured to, in a case that the neutral earthing type of the distribution network is a neutral resonant earthing or a neutral isolated earthing, calculate real parts and imaginary parts of the B-phase, the C-phase, and the A-phase by following equations:

$$\mathrm{Re}Vb = FB \cdot \cos\varphi_B, \mathrm{Im}Vb = FB \cdot \sin\varphi_B,$$

$$\mathrm{Re}Vc = \frac{k3}{k4}, \quad \mathrm{Im}Vc = \mathrm{Re}Vc \cdot \tan(\varphi_C),$$

$$\mathrm{Re}Va = k1 \cdot \mathrm{Re}Vc, \quad \mathrm{Im}Va = \mathrm{Re}Va \cdot \tan(\varphi_A),$$

wherein *ReVa* is the real part of the A-phase voltage, Im *Va* is the imaginary part of the A-phase voltage, Re*Vb* is the real part of the B-phase voltage, Im*Vb* is the imaginary part of the B-phase voltage, Re*Vc* is the real part of the C-phase voltage, Im*Vc* is the imaginary part of the C-phase voltage, and

$$
\begin{cases}
k1 = \dfrac{-\dfrac{\sqrt{3}}{2} + 0.5 \cdot \tan(\varphi_C)}{\tan(\varphi_A)} \\[4ex]
k2 = \dfrac{\dfrac{\sqrt{3}}{2} \cdot \cos\varphi_B + 0.5 \cdot \sin\varphi_B}{\tan(\varphi_A)} FB \\[4ex]
k3 = FB\sin\varphi_B + \dfrac{\sqrt{3}}{2} \cdot k2 - 0.5 \cdot k2 \cdot \tan(\varphi_A) \\[3ex]
k4 = \tan(\varphi_C) + \dfrac{\sqrt{3}}{2} - k1 \cdot \dfrac{\sqrt{3}}{2} - 0.5\tan(\varphi_C) + 0.5 \cdot k1 \cdot \tan(\varphi_A)
\end{cases}
.
$$

13. The device for estimating a phase angle of a zero-sequence voltage of claim 11, further comprises an A-phase current transformer, a B-phase current transformer and a C-phase current transformer, wherein the angle estimator is configured to, in a case that the neutral earthing type of the distribution network is a neutral solidly earthing, determine a magnitude *FC* of the C-phase voltage as a predetermined multiple of the magnitude *FB* of the B-phase voltage, estimates an angle of a negative-sequence impedance at an earth fault detection device, calculates an angle of a negative-sequence current according to three phase currents provided by the A-phase current transformer, the B-phase current transformer and the C-phase current transformer, and estimates the real part and the imaginary part of the A-phase voltage according to following equations:

$$\mathrm{Re}Va = \frac{-\mathrm{Im}Vsum + \tan(\varphi_{V2}) \cdot \mathrm{Re}Vsum}{\tan(\varphi_A) - \tan(\varphi_{V2})}$$

$$\operatorname{Im} Va = \operatorname{Re} Va \cdot \tan(\varphi_A) \, ,$$

wherein Re$Vsum$ is a real part of $\dot{V}_{sum}$, Im$Vsum$ is an imaginary part of the $\dot{V}_{sum}$,

$$\dot{V}_{sum} = \alpha^2 \cdot FB \cdot e^{j\varphi_B} + \alpha \cdot FC \cdot e^{j\varphi_C} \, , \quad \alpha = -0.5 + j\frac{\sqrt{3}}{2} \, ;$$

$\varphi_{V2} = \varphi_{I2} + 180° + \varphi_{Z2}$, $\varphi_{I2}$ is the angle of the negative-sequence current, $\varphi_{Z2}$ is the angle of the negative-sequence impedance, and $\varphi_{V2}$ is an angle of a negative-sequence voltage.

14. The device for estimating a phase angle of a zero-sequence voltage of claim 13, wherein the angle of the negative-sequence impedance at the earth fault detection device is estimated as a first predetermined angle, in a case that the earth fault detection device is far away from the decentralized generating device and loads, and locates at a medium voltage side in the distribution network;
the angle of the negative-sequence impedance at the earth fault detection device is estimated as a second predetermined angle in a case that the earth fault detection device is near to the decentralized generating device and locates at a medium voltage side in the distribution network; and
the angle of the negative-sequence impedance at the earth fault detection device is estimated as a third predetermined angle in a case that the earth fault detection device is near to loads, and locates at a medium voltage side in the distribution network.

**Patentansprüche**

1. Verfahren zum Schätzen eines Phasenwinkels einer Nullspannung, wenn ein einphasiger Erdschluss in einem Verteilungsnetz auftritt, wobei das Verteilungsnetz eine A-Phase mit dem Erdschluss, eine B-Phase und eine C-Phase umfasst, wobei das Verfahren umfasst: Bestimmen (S320) einer neutralen Erdungsart des Verteilungsnetzes; **dadurch gekennzeichnet, dass** das Verfahren umfasst:

   Erfassen (S310) eines Phasenwinkels $\varphi_A$ einer A-Phasenspannung, eines Phasenwinkels $\varphi_B$ einer B-Phasenspannung und eines Phasenwinkels $\varphi_C$ einer C-Phasenspannung;
   Einstellen (S410) einer Größe $FB$ der B-Phasenspannung als vorgegebenen Referenzwert;
   Schätzen (S420) der A-Phasenspannung und der C-Phasenspannung unter Verwendung der Größe der B-Phasenspannung, des Phasenwinkels $\varphi_A$ der A-Phasenspannung, des Phasenwinkels $\varphi_B$ der B-Phasenspannung und des Phasenwinkels $\varphi_C$ der C-Phasenspannung basierend auf der neutralen Erdungsart des Verteilungsnetzes; und
   Berechnen (S430) des Phasenwinkels der Nullspannung unter Verwendung der B-Phasenspannung und der geschätzten A-Phasenspannung und der geschätzten C-Phasenspannung.

2. Verfahren zum Schätzen eines Phasenwinkels einer Nullspannung nach Anspruch 1, **dadurch gekennzeichnet, dass** die neutrale Erdungsart des Verteilungsnetzes eine neutrale Resonanzerdung oder eine neutrale isolierte Erdung ist, wobei die drei Phasenspannungen folgende Gleichungen erfüllen:

$$\begin{cases} \operatorname{Re} Va - \operatorname{Re} Vb = -0.5 \cdot (\operatorname{Re} Vb - \operatorname{Re} Vc) - \frac{\sqrt{3}}{2} \cdot (\operatorname{Im} Vb - j \cdot \operatorname{Im} Vc) \\[2mm] \operatorname{Im} Va - \operatorname{Im} Vb = \frac{\sqrt{3}}{2} \cdot (\operatorname{Re} Vb - \operatorname{Re} Vc) - 0.5 \cdot (\operatorname{Im} Vb - \operatorname{Im} Vc) \\[2mm] \operatorname{Re} Vb - \operatorname{Re} Vc = -0.5 \cdot (\operatorname{Re} Vc - \operatorname{Re} Va) - \frac{\sqrt{3}}{2} \cdot (\operatorname{Im} Vc - j \cdot \operatorname{Im} Va) \\[2mm] \operatorname{Im} Vb - \operatorname{Im} Vc = \frac{\sqrt{3}}{2} \cdot (\operatorname{Re} Vc - \operatorname{Re} Va) - 0.5 \cdot (\operatorname{Im} Vc - \operatorname{Im} Va) \end{cases} ,$$

wobei ReVa der Realteil der A-Phasenspannung ist, ImVa der Imaginärteil der A-Phasenspannung ist, ReVb der Realteil der B-Phasenspannung ist, ImVb der Imaginärteil der B-Phasenspannung ist, ReVc der Realteil der C-Phasenspannung ist und ImVc der Imaginärteil der C-Phasenspannung ist.

3. Verfahren zum Schätzen eines Phasenwinkels einer Nullspannung nach Anspruch 2, **dadurch gekennzeichnet, dass** der Realteil und der Imaginärteil der B-Phase sind:

$$\mathrm{Re}Vb = FB \cdot \cos\varphi_B, \mathrm{Im}Vb = FB \cdot \sin\varphi_B,$$

und die Realteile und die Imaginärteile der A-Phasenspannung und der C-Phasenspannung durch Verwendung der Größe der B-Phasenspannung, des Phasenwinkels $\varphi_B$ der B-Phasenspannung, des Phasenwinkels $\varphi_A$ der A-Phasenspannung und des Phasenwinkels $\varphi_C$ der C-Phasenspannung geschätzt werden:

$$\mathrm{Re}Vc = \frac{k3}{k4}, \mathrm{Im}Vc = \mathrm{Re}Vc \cdot \tan(\varphi_C),$$

$$\mathrm{Re}Va = k1 \cdot \mathrm{Re}Vc + k2, \mathrm{Im}Va = \mathrm{Re}Va \cdot \tan(\varphi_A),$$

wobei

$$\begin{cases} k1 = \dfrac{-\dfrac{\sqrt{3}}{2} + 0.5 \cdot \tan(\varphi_C)}{\tan(\varphi_A)} \\[2em] k2 = \dfrac{\dfrac{\sqrt{3}}{2} \cdot \cos\varphi_B + 0.5 \cdot \sin\varphi_B}{\tan(\varphi_A)} FB \\[2em] k3 = FB\sin\varphi_B + \dfrac{\sqrt{3}}{2} \cdot k2 - 0.5 \cdot k2 \cdot \tan(\varphi_A) \\[1em] k4 = \tan(\varphi_C) + \dfrac{\sqrt{3}}{2} - k1 \cdot \dfrac{\sqrt{3}}{2} - 0.5\tan(\varphi_C) + 0.5 \cdot k1 \cdot \tan(\varphi_A) \end{cases}.$$

4. Verfahren zum Schätzen eines Phasenwinkels einer Nullspannung nach Anspruch 1, **dadurch gekennzeichnet, dass** die neutrale Erdungsart des Verteilungsnetzes eine neutrale feste Erdung ist, wobei das Schätzen der A-Phasenspannung und der C-Phasenspannung umfasst:

Schätzen (S510) einer Größe $FC$ der C-Phasenspannung unter Verwendung der Größe $FB$ der B-Phasenspannung;
Schätzen (S520) einer Gegen-Impedanz an der Erdschlussdetektionsvorrichtung; und
Schätzen (S530) der A-Phasenspannung unter Verwendung des Phasenwinkels $\varphi_A$ der A-Phasenspannung, des Phasenwinkels $\varphi_B$ der B-Phasenspannung und des Phasenwinkels $\varphi_C$ der C-Phasenspannung, der Größen der B-Phasenspannung und der C-Phasenspannung und der geschätzten Gegen-Impedanz an der Erdschlussdetektionsvorrichtung.

5. Verfahren zum Schätzen eines Phasenwinkels einer Nullspannung nach Anspruch 4, **dadurch gekennzeichnet, dass** das Schätzen der Größe der C-Phasenspannung umfasst:

Schätzen einer Proportionalbeziehung zwischen der Größe der B-Phasenspannung und der Größe der C-Phasenspannung; und
Berechnen einer Größe der C-Phasenspannung unter Verwendung der Größe der B-Phasenspannung und der Proportionalbeziehung.

6. Verfahren zum Schätzen eines Phasenwinkels einer Nullspannung nach Anspruch 4, **dadurch gekennzeichnet, dass** das Schätzen der Gegen-Impedanz an der Erdschlussdetektionsvorrichtung umfasst:

Bestimmen einer genauen Position der Erdschlussdetektionsvorrichtung in dem Verteilungsnetz; und
Schätzen der Gegen-Impedanz an der Erdschlussdetektionsvorrichtung auf unterschiedliche Weise gemäß der genauen Position der Erdschlussdetektionsvorrichtung.

7. Verfahren zum Schätzen eines Phasenwinkels einer Nullspannung nach Anspruch 6, **dadurch gekennzeichnet, dass** die Erdschlussdetektionsvorrichtung weit entfernt von der dezentralen Erzeugungsvorrichtung und den Lasten ist und sich auf einer Mittelspannungsseite im Verteilungsnetz befindet, wobei das Schätzen der Gegen-Impedanz an der Erdschlussdetektionsvorrichtung umfasst:

Schätzen einer Netzsystemimpedanz auf einer Hochspannungsseite des Verteilungsnetzes;
Schätzen einer Transformatorimpedanz eines Abwärtstransformators zwischen der Hochspannungsseite und der Mittelspannungsseite in dem Verteilungsnetz;
Bezug nehmen auf die geschätzte Netzsystemimpedanz und die Transformatorimpedanz auf der Mittelspannungsseite, um eine Gegen-Impedanz des Netzes zu erhalten;
Schätzen einer Gegen-Impedanz eines Kabels vom Abwärtstransformator zu der Erdschlussdetektionsvorrichtung; und
Addieren der Gegen-Impedanz des Netzes zu der Gegen-Impedanz des Kabels.

8. Verfahren zum Schätzen eines Phasenwinkels einer Nullspannung nach Anspruch 6, **dadurch gekennzeichnet, dass** sich die Erdschlussdetektionsvorrichtung in der Nähe der dezentralen Erzeugungsvorrichtung befindet und sich auf einer Mittelspannungsseite im Verteilungsnetz befindet, wobei das Schätzen der Gegen-Impedanz an der Erdschlussdetektionsvorrichtung umfasst:

Schätzen der Impedanz einer Erzeugungsvorrichtung der dezentralen Erzeugungsvorrichtung;
Schätzen einer Transformatorimpedanz eines Aufwärtstransformators zwischen der dezentralen Erzeugungsvorrichtung und der Mittelspannungsseite im Verteilungsnetz;
Bezug nehmen auf die geschätzte Impedanz der Erzeugungsvorrichtung und die Transformatorimpedanz auf der Mittelspannungsseite, um eine Gegen-Impedanz der Erzeugungsvorrichtung zu erhalten;
Schätzen einer Gegen-Impedanz eines Kabels vom Aufwärtstransformator zu der Erdschlussdetektionsvorrichtung; und
Addieren der Gegen-Impedanz der Erzeugungsvorrichtung zur Gegen-Impedanz des Kabels.

9. Verfahren zum Schätzen eines Phasenwinkels einer Nullspannung nach Anspruch 4, **dadurch gekennzeichnet, dass** das Schätzen der A-Phasenspannung umfasst:

Berechnen eines Phasenwinkels der Gegen-Spannung unter Verwendung des geschätzten Winkels der Gegen-Impedanz an der Erdschlussdetektionsvorrichtung und des Phasenwinkels des Gegen-Stroms; und
Schätzen eines Realteils und eines Imaginärteils der A-Phasenspannung unter Verwendung des Phasenwinkels $\varphi_A$ der A-Phasenspannung, des Phasenwinkels $\varphi_B$ der B-Phasenspannung und des Phasenwinkels $\varphi_C$ der C-Phasenspannung, der Größen der B-Phasenspannung und der C-Phasenspannung und des Phasenwinkels der Gegen-Spannung.

10. Verfahren zum Schätzen eines Phasenwinkels einer Nullspannung nach Anspruch 9, **dadurch gekennzeichnet, dass** der Realteil und der Imaginärteil der A-Phasenspannung wie folgt sind:

$$\mathrm{Re}\,Va = \frac{-\mathrm{Im}\,Vsum + tan(\varphi_{V2}) \cdot \mathrm{Re}\,Vsum}{tan(\varphi_A) - tan(\varphi_{V2})}$$

$$\mathrm{Im}\,Va = \mathrm{Re}\,Va \cdot \tan(\varphi_A)\,,$$

wobei ReVsum ein Realteil von $\dot{V}_{sum}$ ist, ImVsum ein Imaginärteil von $\dot{V}_{sum}$ ist,

$$\dot{V}_{sum} = \alpha^2 \cdot FB \cdot e^{j\varphi_B} + \alpha \cdot FC \cdot e^{j\varphi_C}, \quad \alpha = -0.5 + j\frac{\sqrt{3}}{2};$$

$\varphi_{V2} = \varphi_{I2} + 180° + \varphi_{Z2}$, wobei $\varphi_{I2}$ der Phasenwinkel des Gegen-Stroms ist, $\varphi_{Z2}$ der Phasenwinkel der Gegen-Impedanz ist und $\varphi_{V2}$ der Phasenwinkel der Gegen-Spannung ist.

11. Vorrichtung zum Schätzen eines Phasenwinkels einer Nullspannung, wenn ein einphasiger Erdschluss in einem Verteilungsnetz auftritt, wobei das Verteilungsnetz eine A-Phase mit dem Erdschluss, eine B-Phase und eine C-Phase umfasst, wobei die Vorrichtung **dadurch gekennzeichnet ist, dass** sie umfasst:

einen Winkeldetektor, der konfiguriert ist, um einen Phasenwinkel $\varphi_A$ einer A-Phasenspannung zu erfassen, einen Winkeldetektor, der konfiguriert ist, um einen Phasenwinkel $\varphi_B$ einer B-Phasenspannung zu erfassen, und einen Winkeldetektor, der konfiguriert ist, um einen Phasenwinkel $\varphi_C$ einer C-Phasenspannung zu erfassen; und

einen Winkelschätzer, der konfiguriert ist, um eine Größe *FB* der B-Phasenspannung als vorbestimmten Referenzwert einzustellen, um die A-Phasenspannung und die C-Phasenspannung unter Verwendung der Größe der B-Phasenspannung, des Phasenwinkels $\varphi_A$ der A-Phasenspannung, des Phasenwinkels $\varphi_B$ der B-Phasenspannung und des Phasenwinkels $\varphi_C$ der C-Phasenspannung basierend auf einem neutralen Erdungstyp des Verteilungsnetzes zu schätzen; und um den Phasenwinkel der Nullspannung unter Verwendung der B-Phasenspannung und der geschätzten A-Phasenspannung und der geschätzten C-Phasenspannung zu berechnen.

12. Vorrichtung zum Schätzen eines Phasenwinkels einer Nullspannung nach Anspruch 11, wobei der Winkelschätzer konfiguriert ist, um in einem Fall, bei dem die neutrale Erdungsart des Verteilungsnetzes eine neutrale Resonanzerdung oder eine neutrale isolierte Erdung ist, Realteile und Imaginärteile der B-Phase, der C-Phase und der A-Phase durch folgende Gleichungen zu berechnen:

$$\mathrm{Re}Vb = FB \cdot \cos\varphi_B, \mathrm{Im}Vb = FB \cdot \sin\varphi_B,$$

$$\mathrm{Re}Vc = \frac{k3}{k4}, \mathrm{Im}Vc = \mathrm{Re}Vc \cdot \tan(\varphi_C),$$

$$\mathrm{Re}Va = k1 \cdot \mathrm{Re}Vc + k2, \mathrm{Im}Va = \mathrm{Re}Va \cdot \tan(\varphi_A),$$

wobei ReVa der Realteil der A-Phasenspannung ist, ImVa der Imaginärteil der A-Phasenspannung ist, ReVb der Realteil der B-Phasenspannung ist, ImVb der Imaginärteil der B-Phasenspannung ist, ReVc der Realteil der C-Phasenspannung ist, ImVc der Imaginärteil der C-Phasenspannung ist und

$$\begin{cases} k1 = \dfrac{-\dfrac{\sqrt{3}}{2} + 0.5 \cdot \tan(\varphi_C)}{\tan(\varphi_A)} \\[4ex] k2 = \dfrac{\dfrac{\sqrt{3}}{2} \cdot \cos\varphi_B + 0.5 \cdot \sin\varphi_B}{\tan(\varphi_A)} FB \\[4ex] k3 = FB\sin\varphi_B + \dfrac{\sqrt{3}}{2} \cdot k2 - 0.5 \cdot k2 \cdot \tan(\varphi_A) \\[2ex] k4 = \tan(\varphi_C) + \dfrac{\sqrt{3}}{2} - k1 \cdot \dfrac{\sqrt{3}}{2} - 0.5\tan(\varphi_C) + 0.5 \cdot k1 \cdot \tan(\varphi_A) \end{cases}.$$

**13.** Vorrichtung zum Schätzen eines Phasenwinkels einer Nullspannung nach Anspruch 11, die ferner einen A-Phasen-Stromwandler, einen B-Phasen-Stromwandler und einen C-Phasen-Stromwandler umfasst,
wobei der Winkelschätzer konfiguriert ist, um in einem Fall, bei dem die neutrale Erdungsart des Verteilungsnetzes eine neutrale feste Erdung ist, eine Größe *FC* der C-Phasenspannung als ein vorgegebenes Vielfaches der Größe *FB* der B-Phasenspannung zu bestimmen, einen Winkel einer Gegen-Impedanz an einer Erdschlussdetektionsvorrichtung zu schätzen, einen Winkel eines Gegen-Stroms gemäß drei Phasenströmen, die von dem A-Phasen-Stromwandler, dem B-Phasen-Stromwandler und dem C-Phasen-Stromwandler bereitgestellt werden, zu berechnen und den Realteil und den Imaginärteil der A-Phasenspannung gemäß den folgenden Gleichungen zu schätzen:

$$\operatorname{Re}Va = \frac{-\operatorname{Im}Vsum + tan(\varphi_{V2}) \cdot \operatorname{Re}Vsum}{tan(\varphi_A) - tan(\varphi_{V2})}$$

$$\operatorname{Im}Va = \operatorname{Re}Va \cdot \tan(\varphi_A) \,,$$

wobei ReVsum ein Realteil von $\dot{V}_{sum}$ ist, ImVsum ein Imaginärteil von $\dot{V}_{sum}$ ist, $\dot{V}_{sum} = \alpha^2 \cdot FB \cdot e^{j\varphi_B} + \alpha \cdot FC \cdot e^{j\varphi_C}$,

$$\alpha = -0.5 + j\frac{\sqrt{3}}{2} \,;$$

$\varphi_{V2} = \varphi_{I2} + 180° + \varphi_{Z2}$, wobei $\varphi_{I2}$ der Winkel des Gegen-Stroms, ist $\varphi_{Z2}$ der Winkel der Gegen-Impedanz ist und $\varphi_{V2}$ ein Winkel einer Gegen-Spannung ist.

**14.** Vorrichtung zum Schätzen eines Phasenwinkels einer Nullspannung nach Anspruch 13, wobei der Winkel der Gegen-Impedanz an der Erdschlussdetektionsvorrichtung als erster vorgegebener Winkel geschätzt wird, in einem Fall, bei dem die Erdschlussdetektionsvorrichtung weit von der dezentralen Erzeugungsvorrichtung und den Lasten entfernt ist und sich auf einer Mittelspannungsseite im Verteilungsnetz befindet;
der Winkel der Gegen-Impedanz an der Erdschlussdetektionsvorrichtung als zweiter vorgegebener Winkel in einem Fall geschätzt wird, bei dem sich die Erdschlussdetektionsvorrichtung in der Nähe der dezentralen Erzeugungsvorrichtung befindet und sich auf einer Mittelspannungsseite im Verteilungsnetz befindet; und
der Winkel der Gegen-Impedanz an der Erdschlussdetektionsvorrichtung als dritter vorgegebener Winkel in einem Fall geschätzt wird, bei dem sich die Erdschlussdetektionsvorrichtung in der Nähe von Lasten befindet und sich auf einer Mittelspannungsseite im Verteilungsnetz befindet.

## Revendications

**1.** Procédé d'estimation d'un angle de phase d'une tension homopolaire lorsqu'un défaut à la terre monophasé se produit dans un réseau de distribution, le réseau de distribution comprenant une phase A présentant le défaut à la terre, une phase B et une phase C, le procédé consistant à : déterminer (S320) un type de mise à la terre du neutre du réseau de distribution ;
**caractérisé en ce que** le procédé comprend les étapes consistant à :

détecter (S310) un angle de phase $\varphi_A$ d'une tension de phase A, un angle de phase $\varphi_B$ d'une tension de phase B et un angle de phase $\varphi_C$ d'une tension de phase C;
définir (S410) une amplitude *FB* de la tension de phase B comme valeur de référence prédéterminée ;
estimer (S420) la tension de phase A et la tension de phase C en utilisant l'amplitude de la tension de phase B, l'angle de phase $\varphi_A$ de la tension de phase A, l'angle de phase $\varphi_B$ de la tension de phase B et l'angle de phase $\varphi_C$ de la tension de phase C, sur la base du type de mise à la terre du neutre du réseau de distribution ; et
calculer (S430) l'angle de phase de la tension homopolaire en utilisant la tension de phase B, la tension de phase A estimée et la tension de phase C estimée.

**2.** Procédé d'estimation d'un angle de phase d'une tension homopolaire selon la revendication 1, **caractérisé en ce que** le type de mise à la terre du neutre du réseau de distribution est une mise à la terre à neutre résonant ou une mise à la terre à neutre isolé, les trois tensions de phase satisfont aux équations suivantes :

$$\begin{cases} \mathrm{Re}\,Va - \mathrm{Re}\,Vb = -0.5 \cdot (\mathrm{Re}\,Vb - \mathrm{Re}\,Vc) - \frac{\sqrt{3}}{2} \cdot (\mathrm{Im}\,Vb - j \cdot \mathrm{Im}\,Vc) \\[2mm] \mathrm{Im}\,Va - \mathrm{Im}\,Vb = \frac{\sqrt{3}}{2} \cdot (\mathrm{Re}\,Vb - \mathrm{Re}\,Vc) - 0.5 \cdot (\mathrm{Im}\,Vb - \mathrm{Im}\,Vc) \\[2mm] \mathrm{Re}\,Vb - \mathrm{Re}\,Vc = -0.5 \cdot (\mathrm{Re}\,Vc - \mathrm{Re}\,Va) - \frac{\sqrt{3}}{2} \cdot (\mathrm{Im}\,Vc - j \cdot \mathrm{Im}\,Va) \\[2mm] \mathrm{Im}\,Vb - \mathrm{Im}\,Vc = \frac{\sqrt{3}}{2} \cdot (\mathrm{Re}\,Vc - \mathrm{Re}\,Va) - 0.5 \cdot (\mathrm{Im}\,Vc - \mathrm{Im}\,Va) \end{cases},$$

où $\mathrm{Re}\,Va$ est la partie réelle de la tension de phase A, $\mathrm{Im}\,Va$ est la partie imaginaire de la tension de phase A, $\mathrm{Re}\,Vb$ est la partie réelle de la tension de phase B, $\mathrm{Im}\,Vb$ est la partie imaginaire de la tension de phase B, $\mathrm{Re}\,Vc$ est la partie réelle de la tension de phase C, $\mathrm{Im}\,Vc$ est la partie imaginaire de la tension de phase C.

3. Procédé d'estimation d'un angle de phase d'une tension homopolaire selon la revendication 2, **caractérisé en ce que** la partie réelle et la partie imaginaire de la phase B sont :

$$\mathrm{Re}\,Vb = FB \cdot \cos\varphi_B, \quad \mathrm{Im}\,Vb = FB \cdot \sin\varphi_B,$$

et les parties réelles et les parties imaginaires de la tension de phase A et de la tension de phase C sont estimées en utilisant l'amplitude de la tension de phase B, l'angle de phase $\varphi_B$ de la tension de phase B, l'angle de phase $\varphi_A$ de la tension de phase A et l'angle de phase $\varphi_C$ de la tension de phase C :

$$\mathrm{Re}\,Vc = \frac{k3}{k4}, \quad \mathrm{Im}\,Vc = \mathrm{Re}\,Vc \cdot \tan(\varphi_C),$$

$$\mathrm{Re}\,Va = k1 \cdot \mathrm{Re}\,Vc, \quad \mathrm{Im}\,Va = \mathrm{Re}\,Va \cdot \tan(\varphi_A);$$

où

$$\begin{cases} k1 = \dfrac{-\frac{\sqrt{3}}{2} + 0.5 \cdot \tan(\varphi_C)}{\tan(\varphi_A)} \\[4mm] k2 = \dfrac{\frac{\sqrt{3}}{2} \cdot \cos\varphi_B + 0.5 \cdot \sin\varphi_B}{\tan(\varphi_A)} FB \\[4mm] k3 = FB\sin\varphi_B + \frac{\sqrt{3}}{2} \cdot k2 - 0.5 \cdot k2 \cdot \tan(\varphi_A) \\[2mm] k4 = \tan(\varphi_C) + \frac{\sqrt{3}}{2} - k1 \cdot \frac{\sqrt{3}}{2} - 0.5\tan(\varphi_C) + 0.5 \cdot k1 \cdot \tan(\varphi_A) \end{cases}$$

4. Procédé d'estimation d'un angle de phase d'une tension homopolaire selon la revendication 1, **caractérisé en ce que** le type de mise à la terre neutre du réseau de distribution est une mise à la terre à neutre solide, ladite estimation de la tension de phase A et de la tension de phase C comprenant les étapes consistant à :

estimer (S510) une amplitude $FC$ de la tension de phase C en utilisant l'amplitude $FB$ de la tension de phase B ;
estimer (S520) une impédance inverse au dispositif de détection de défaut à la terre ; et
estimer (S530) la tension de phase A en utilisant l'angle de phase $\varphi_A$ de la tension de phase A, l'angle de phase $\varphi_B$ de la tension de phase B et l'angle de phase $\varphi_C$ de la tension de phase C, les amplitudes de la tension de phase B et de la tension de phase C, et l'impédance inverse estimée au dispositif de détection de défaut à la terre.

**5.** Procédé d'estimation d'un angle de phase d'une tension homopolaire selon la revendication 4, **caractérisé en ce que** ladite estimation de l'amplitude de la tension de phase C comprend les étapes consistant à :

estimer une relation de proportion entre l'amplitude de la tension de phase B et l'amplitude de la tension de phase C ; et
calculer une amplitude de la tension de phase C en utilisant l'amplitude de la tension de phase B et la relation de proportion.

**6.** Procédé d'estimation d'un angle de phase d'une tension homopolaire selon la revendication 4, **caractérisé en ce que** ladite estimation de l'impédance inverse au dispositif de détection de défaut à la terre comprend les étapes consistant à :

déterminer une position exacte du dispositif de détection de défaut à la terre dans le réseau de distribution ; et
estimer l'impédance inverse au dispositif de détection de défaut à la terre, différemment en fonction de la position exacte du dispositif de détection de défaut à la terre.

**7.** Procédé d'estimation d'un angle de phase d'une tension homopolaire selon la revendication 6, **caractérisé en ce que** le dispositif de détection de défaut à la terre est éloigné du dispositif générateur décentralisé et de charges, et se situe d'un côté moyenne tension dans le réseau de distribution, ladite estimation de l'impédance inverse au dispositif de détection de défaut à la terre comprenant les étapes consistant à :

estimer une impédance de réseau d'un côté haute tension du réseau de distribution ;
estimer une impédance de transformateur d'un transformateur abaisseur entre le côté haute tension et le côté moyenne tension dans le réseau de distribution ;
référencer l'impédance de réseau estimée et l'impédance de transformateur au côté moyenne tension pour obtenir une impédance inverse de réseau ;
estimer une impédance inverse de câble entre le transformateur abaisseur et le dispositif de détection de défaut à la terre ; et
additionner l'impédance inverse de réseau à l'impédance inverse de câble.

**8.** Procédé d'estimation d'un angle de phase d'une tension homopolaire selon la revendication 6, **caractérisé en ce que** le dispositif de détection de défaut à la terre est proche du dispositif générateur décentralisé et se situe d'un côté moyenne tension dans le réseau de distribution, ladite estimation de l'impédance inverse au dispositif de détection de défaut à la terre comprenant les étapes consistant à :

estimer une impédance de dispositif générateur du dispositif générateur décentralisé ;
estimer une impédance de transformateur d'un transformateur élévateur entre le dispositif générateur décentralisé et le côté moyenne tension dans le réseau de distribution ;
référencer l'impédance de dispositif générateur estimée et l'impédance de transformateur au côté moyenne tension pour obtenir une impédance inverse de dispositif générateur ;
estimer une impédance inverse de câble entre le transformateur élévateur et le dispositif de détection de défaut à la terre ; et
additionner l'impédance inverse de dispositif générateur à l'impédance inverse de câble.

**9.** Procédé d'estimation d'un angle de phase d'une tension homopolaire selon la revendication 4, **caractérisé en ce que** ladite estimation de la tension de phase A comprend les étapes consistant à :

calculer un angle de phase de la tension inverse en utilisant l'angle estimé de l'impédance inverse au dispositif de détection de défaut à la terre et l'angle de phase du courant inverse ; et
estimer une partie réelle et une partie imaginaire de la tension de phase A en utilisant l'angle de phase $\varphi_A$ de la tension de phase A, l'angle de phase $\varphi_B$ de la tension de phase B et l'angle de phase $\varphi_C$ de la tension de phase C, les amplitudes de la tension de phase B et la tension de phase C, et l'angle de phase de la tension inverse.

**10.** Procédé d'estimation d'un angle de phase d'une tension homopolaire selon la revendication 9, **caractérisé en ce que** la partie réelle et la partie imaginaire de la tension de phase A sont comme suit :

$$\mathrm{Re}\,Va = \frac{-\mathrm{Im}\,Vsum + tan(\varphi_{V2})\cdot \mathrm{Re}\,Vsum}{tan(\varphi_A) - tan(\varphi_{V2})}$$

$$\mathrm{Im}\,Va = \mathrm{Re}\,Va \cdot tan(\varphi_A)\,,$$

où Re$Vsum$ est une partie réelle de $\dot{V}_{sum}$, $ImVsum$ est une partie imaginaire de $\dot{V}_{sum}$,

$$\dot{V}_{sum} = \alpha^2 \cdot FB \cdot e^{j\varphi_B} + \alpha \cdot FC \cdot e^{j\varphi_c}\,, \quad \alpha = -0.5 + j\frac{\sqrt{3}}{2}\,;$$

$\varphi_{V2} = \varphi_{I2} + 180° + \varphi_{Z2}$, $\varphi_{I2}$ est l'angle de phase du courant inverse, $\varphi_{Z2}$ est l'angle de phase de l'impédance inverse et $\varphi_{V2}$ est l'angle de phase de la tension inverse.

11. Dispositif pour estimer un angle de phase d'une tension homopolaire lorsqu'un défaut à la terre monophasé se produit dans un réseau de distribution, le réseau de distribution comprenant une phase A présentant le défaut à la terre, une phase B et une phase C, le dispositif étant **caractérisé en ce qu'**il comprend :

un détecteur d'angle configuré pour détecter un angle de phase $\varphi_A$ d'une tension de phase A, un détecteur d'angle configuré pour détecter un angle de phase $\varphi_B$ d'une tension de phase B et un détecteur d'angle configuré pour détecter un angle de phase $\varphi_C$ d'une tension de phase C ; et

un estimateur d'angle configuré pour définir une amplitude $FB$ de la tension de phase B comme valeur de référence prédéterminée, pour estimer la tension de phase A et la tension de phase C en utilisant l'amplitude de la tension de phase B, l'angle de phase $\varphi_A$ de la tension de phase A, l'angle de phase $\varphi_B$ de la tension de phase B et l'angle de phase $\varphi_C$ de la tension de phase C, sur la base d'un type de mise à la terre du neutre du réseau de distribution ; et pour calculer l'angle de phase de la tension homopolaire en utilisant la tension de phase B, la tension de phase A estimée et la tension de phase C estimée.

12. Dispositif d'estimation d'un angle de phase d'une tension homopolaire selon la revendication 11, dans lequel l'estimateur d'angle est configuré pour, dans le cas où le type de mise à la terre du neutre du réseau de distribution est une mise à la terre à neutre résonant ou une mise à la terre à neutre isolé, calculer des parties réelles et imaginaires de la phases B, de la phase C et de la phase A par les équations suivantes :

$$\mathrm{Re}\,Vb = FB \cdot \cos\varphi_B, \mathrm{Im}\,Vb = FB \cdot \sin\varphi_B\,,$$

$$\mathrm{Re}\,Vc = \frac{k3}{k4}\,, \quad \mathrm{Im}\,Vc = \mathrm{Re}\,Vc \cdot tan(\varphi_C)\,,$$

$$\mathrm{Re}\,Va = k1 \cdot \mathrm{Re}\,Vc\,, \quad \mathrm{Im}\,Va = \mathrm{Re}\,Va \cdot tan(\varphi_A)\,,$$

où Re$Va$ est la partie réelle de la tension de phase A, Im$Va$ est la partie imaginaire de la tension de phase A, Re$Vb$ est la partie réelle de la tension de phase B, Im$Vb$ est la partie imaginaire de la tension de phase B, Re$Vc$ est la partie réelle de la tension de phase C, Im$Vc$ est la partie imaginaire de la tension de phase C, et

$$\begin{cases} k1 = \dfrac{-\dfrac{\sqrt{3}}{2} + 0.5 \cdot \tan(\varphi_C)}{\tan(\varphi_A)} \\[4mm] k2 = \dfrac{\dfrac{\sqrt{3}}{2} \cdot \cos\varphi_B + 0.5 \cdot \sin\varphi_B}{\tan(\varphi_A)} FB \\[4mm] k3 = FB\sin\varphi_B + \dfrac{\sqrt{3}}{2} \cdot k2 - 0.5 \cdot k2 \cdot \tan(\varphi_A) \\[4mm] k4 = \tan(\varphi_C) + \dfrac{\sqrt{3}}{2} - k1 \cdot \dfrac{\sqrt{3}}{2} - 0.5\tan(\varphi_C) + 0.5 \cdot k1 \cdot \tan(\varphi_A) \end{cases}$$

**13.** Dispositif d'estimation d'un angle de phase d'une tension homopolaire selon la revendication 11, comprenant en outre un transformateur de courant de phase A, un transformateur de courant de phase B et un transformateur de courant de phase C,

dans lequel l'estimateur d'angle est configuré pour, dans le cas où le type de mise à la terre du neutre du réseau de distribution est une mise à la terre à neutre solide, déterminer une amplitude $FC$ de la tension de phase C comme un multiple prédéterminé de l'amplitude $FB$ de la tension de phase B, estimer un angle d'une impédance inverse à un dispositif de détection de défaut à la terre, calculer un angle d'un courant inverse en fonction de trois courants de phase fournis par le transformateur de courant de phase A, le transformateur de courant de phase B et le transformateur de courant de phase C, et estimer la partie réelle et la partie imaginaire de la tension de phase A selon les équations suivantes :

$$\mathrm{Re}Va = \frac{-\mathrm{Im}\,Vsum + tan(\varphi_{V2}) \cdot \mathrm{Re}\,Vsum}{tan(\varphi_A) - tan(\varphi_{V2})}$$

$$\mathrm{Im}\,Va = \mathrm{Re}\,Va \cdot \tan(\varphi_A),$$

où $\mathrm{Re}Vsum$ est une partie réelle de $\dot{V}_{sum}$, $\mathrm{Im}Vsum$ est une partie imaginaire de $\dot{V}_{sum}$,

$$\dot{V}_{sum} = \alpha^2 \cdot FB \cdot e^{j\varphi_B} + \alpha \cdot FC \cdot e^{j\varphi_C}, \quad \alpha = -0.5 + j\frac{\sqrt{3}}{2};$$

$\varphi_{V2} = \varphi_{I2} + 180° + \varphi_{Z2}$, $\varphi_{I2}$ est l'angle du courant inverse, $\varphi_{Z2}$ est l'angle de l'impédance inverse et $\varphi_{V2}$ est un angle d'une tension inverse.

**14.** Dispositif d'estimation d'un angle de phase d'une tension homopolaire selon la revendication 13, dans lequel l'angle de l'impédance inverse au dispositif de détection de défaut à la terre est estimé comme un premier angle prédéterminé dans le cas où le dispositif de détection de défaut à la terre est éloigné du dispositif générateur décentralisé et de charges, et se situe d'un côté moyenne tension dans le réseau de distribution ;

l'angle de l'impédance inverse au dispositif de détection de défaut à la terre est estimé comme un deuxième angle prédéterminé dans le cas où le dispositif de détection de défaut à la terre est proche du dispositif générateur décentralisé et se situe d'un côté moyenne tension dans le réseau de distribution ; et

l'angle de l'impédance inverse au dispositif de détection de défaut à la terre est estimé comme un troisième angle prédéterminé dans le cas où le dispositif de détection de défaut à la terre est proche de charges et se situe d'un côté moyenne tension dans le réseau de distribution.

Fig.1

Fig.2A

Fig.2B

Fig.2C

300

S301      ( start )

S310      angles of respective phase voltages in three phase voltages are detected

S320      a neutral earthing type of the distribution network is determined

S330      the angle of the zero-sequence voltage when the single-phase earth fault occurs in the distribution network is estimated with the detected angles of the respective phase voltages, according to the neutral earthing type of the distribution network

S399      ( end )

Fig.3

S410      a magnitude FB of the B-phase voltage is set as a predetermined reference value

S420      an A-phase voltage and a C-phase voltage are estimated by using the magnitude of the B-phase voltage and the angles of the A-phase voltage, the B-phase voltage, and the C-phase voltage

S430      the angle of the zero-sequence voltage is calculated by using the B-phase voltage and the estimated A-phase voltage and the estimated C-phase voltage

Fig.4

| S510 | the magnitude *FC* of the C-phase voltage is estimated with the magnitude *FB* of the B-phase voltage |
|---|---|

| S520 | a negative-sequence impedance at the earth fault detection device is estimated |
|---|---|

| S530 | the A-phase voltage is estimated with the angles of the A-phase voltage, the B-phase voltage and the C-phase voltage, the magnitudes of the B-phase voltage and the C-phase voltage, and with the estimated negative-sequence impedance at the earth fault detection device |
|---|---|

Fig.5

Real CR

Fig.6

Fig.7

Fig.8

Fig.9

Fig.10

Fig.11

Fig.12

Fig.13

Fig.14

| A-phase current transformer | angle detector for A-phase voltage |
| B-phase current transformer | angle detector for B-phase voltage |
| C-phase current transformer | angle detector for C-phase voltage |
| angle estimator for zero-sequence voltage | |

Fig.15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1682909 B1